# EUROPEAN PATENT APPLICATION

(11) **EP 4 567 840 A1**
(43) Date of publication of application: **11.06.2025**
(21) Application number: 24217917.4
(22) Date of filing: 05.12.2024
(51) Int. Cl.: H01F 1/26, H01F 1/37

(54) **RESIN COMPOSITION**

(30) Priority: 07.12.2023 JP 2023207049
(71) Applicant: Ajinomoto Co., Inc., Tokyo 104-8315 (JP)
(72) Inventor: TANAKA, Takayuki, Kawasaki-shi, 210-0801 (JP); OOYAMA, Hideki, Kawasaki-shi, 210-0801 (JP)
(74) Representative: Mewburn Ellis LLP

(57) **Abstract**

Provided is a resin composition including a component (A) that is an Fe-Ni-Si-Cr-based alloy magnetic powder, and a component (B) that is a thermosetting resin, wherein
a content of Cr contained in the component (A) is 0.1% by mass or more and 6% by mass or less relative to 100% by mass of the component (A).

## Description

### BACKGROUND OF THE INVENTION

### 1. Field of the Invention

The present invention relates to a resin composition, as well as a cured product, a magnetic paste, a resin sheet, a circuit substrate, and an inductor substrate that include the resin composition.

### 2. Description of the Related Art

As a core material of an inductor part, a cured product that is obtained by curing a resin composition containing a magnetic powder is used in some cases. As the magnetic powder, an FeNi alloy powder has been used in some cases (Japanese Patent Application Laid-Open No. 2018-178254 A).

### SUMMARY OF THE INVENTION

Conventionally, an inductor part has been independently mounted on a substrate of a semiconductor device in general. However, in recent years, a method of forming a coil by a conductor pattern of a substrate to dispose an inductor element inside the substrate has been performed in some cases. In order to further enhance performance of the inductor element used in such an application, the magnetic properties of the core material are required to be further improved. Furthermore, when a substrate of a semiconductor device has holes, the holes are filled with a resin composition containing a magnetic powder in some cases. In this case, the melt viscosity of the resin composition is required to be low.

The present invention has been devised in view of the above-mentioned problems, and an object of the present invention is to provide a resin composition having a low melt viscosity from which a cured product having a high relative magnetic permeability and a low magnetic loss can be obtained; a cured product of the resin composition; a magnetic paste and a resin sheet each containing the resin composition; and a circuit substrate and an inductor substrate each containing a cured product of the resin composition.

### SUMMARY OF THE INVENTION

The present inventor intensively studied for solving the above-mentioned problems. As a result, the present inventor has found that the problems can be solved by a resin composition containing a combination of an Fe-Ni-Si-Cr-based alloy magnetic powder (A) containing specific amounts of Si and Cr and a thermosetting resin (B), thereby completing the present invention.

Namely, the present invention includes following contents.
[1] A resin composition comprising:
   a component (A) that is an Fe-Ni-Si-Cr-based alloy magnetic powder; and
   a component (B) that is a thermosetting resin, wherein
   a content of Cr contained in the component (A) is 0.1% by mass or more and 6% by mass or less relative to 100% by mass of the component (A).
[2] The resin composition according to [1], further comprising a component (C) that is a magnetic powder other than an Fe-Ni-Si-Cr-based alloy magnetic powder.
[3] The resin composition according to [2], wherein the component (C) contains a ferrite-based magnetic powder.
[4] The resin composition according to [2] or [3], wherein the component (C) contains a ferrite-based magnetic powder containing at least one element selected from the group consisting of Mn, Zn, Ni, and Cu.
[5] The resin composition according to any one of [2] to [4], wherein the component (C) has a smaller average particle diameter than that of the component (A).
[6] The resin composition according to any one of [1] to [5], wherein the component (B) contains an epoxy resin (B-1) .
[7] The resin composition according to any one of [1] to [6], wherein the component (B) contains a curing agent (B-2) .
[8] The resin composition according to any one of [1] to [7], further comprising a dispersant (E).
[9] The resin composition according to any one of [1] to [8], further comprising a curing accelerator (F).
[10] The resin composition according to any one of [1] to [9], wherein a content of Si contained in the component (A) is 0.2% by mass or more and 5% by mass or less relative to 100% by mass of the component (A).
[11] The resin composition according to any one of [1] to [10], wherein a content of Cr contained in the component (A) is 0.5% by mass or more and 6% by mass or less relative to 100% by mass of the component (A).
[12] The resin composition according to any one of [1] to [11], wherein an amount of the component (A) is 40% by mass or more relative to 100% by mass of non-volatile components in the resin composition.
[13] The resin composition according to any one of [1] to [12], wherein an amount of the component (A) is 30% by volume or more relative to 100% by volume of non-volatile components in the resin composition.
[14] The resin composition according to any one of [2] to [13], wherein a total amount of the component (A) and the component (C) is 70% by mass or more relative to 100% by mass of non-volatile components in the resin composition.
[15] The resin composition according to any one of [2] to [14], wherein a total amount of the component (A) and the component (C) is 50% by volume or more relative to 100% by volume of non-volatile components in the resin composition.
[16] The resin composition according to any one of [1] to [15], serving as a hole-filling resin composition.
[17] A cured product of the resin composition according to any one of [1] to [16].
[18] A magnetic paste comprising the resin composition according to any one of [1] to [16].
[19] A resin sheet comprising a support and a resin composition layer provided on the support, wherein
   the resin composition layer includes the resin composition according to any one of [1] to [16].
[20] A circuit substrate comprising a substrate having holes and a cured product of the resin composition according to any one of [1] to [16] with which the holes are filled.
[21] A circuit substrate comprising a cured product layer including a cured product of the resin composition according to any one of [1] to [16].
[22] An inductor substrate comprising a circuit substrate according to [20] or [21].

### Advantageous Effects of Invention

According to the present invention, there can be provided a resin composition having a low melt viscosity from which a cured product a having high relative magnetic permeability and a low magnetic loss can be obtained; a cured product of the resin composition; a magnetic paste and a resin sheet each containing the resin composition; and a circuit substrate and an inductor substrate each containing a cured product of the resin composition.

### BRIEF DESCRIPTION OF THE DRAWINGS

Fig. 1 is a cross-sectional view schematically illustrating a core substrate prepared in a method for producing a circuit substrate according to a first example of an embodiment of the present invention.
Fig. 2 is a cross-sectional view schematically illustrating a core substrate in which through holes are formed in the method for producing a circuit substrate according to the first example of the embodiment of the present invention.
Fig. 3 is a cross-sectional view schematically illustrating a core substrate in which plated layers are formed inside the through holes in the method for producing a circuit substrate according to the first example of the embodiment of the present invention.
Fig. 4 is a cross-sectional view schematically illustrating that the through holes of the core substrate are filled with a resin composition in the method for producing a circuit substrate according to the first example of the embodiment of the present invention.
Fig. 5 is a schematic cross-sectional view for explaining step (2) of the method for producing a circuit substrate according to the first example of the embodiment of the present invention.
Fig. 6 is a schematic cross-sectional view for explaining step (3) of the method for producing a circuit substrate according to the first example of the embodiment of the present invention.
Fig. 7 is a schematic cross-sectional view for explaining step (5) of the method for producing a circuit substrate according to the first example of the embodiment of the present invention.
Fig. 8 is a schematic cross-sectional view for explaining step (5) of the method for producing a circuit substrate according to the first example of the embodiment of the present invention.
Fig. 9 is a schematic cross-sectional view for explaining step (i) in a method for producing a circuit substrate according to a second example of an embodiment of the present invention.
Fig. 10 is a schematic cross-sectional view for explaining step (i) in the method for producing a circuit substrate according to the second example of the embodiment of the present invention.
Fig. 11 is a schematic cross-sectional view for explaining step (ii) in the method for producing a circuit substrate according to the second example of the embodiment of the present invention.
Fig. 12 is a schematic cross-sectional view for explaining step (iv) in the method for producing a circuit substrate according to the second example of the embodiment of the present invention.
Fig. 13 is a schematic plan view when a circuit substrate of an inductor substrate is seen from one side of the thickness direction.
Fig. 14 is a schematic view illustrating a cut end surface of the circuit substrate cut along a dash-dotted line II-II shown in Fig. 13.
Fig. 15 is a schematic plan view for explaining a configuration of a first conductor layer of a circuit substrate of an inductor substrate.

### DETAILED DESCRIPTION OF THE PREFERRED EMBODIMENTS

Hereinafter, the present invention will be described in detail according to its suitable embodiments. However, the present invention is not limited to the following embodiments and examples, and can be optionally modified for implementation within the range that does not depart from the scope of claims and their equivalents.

In the following description, a "resin component" of a resin composition refers to a component, other than inorganic particles such as a magnetic powder, among non-volatile components contained in the resin composition.

In the following description, a "magnetic permeability" refers to a "relative magnetic permeability" unless otherwise stated.

### <Resin composition>

The resin composition of the present invention is a resin composition containing an Fe-Ni-Si-Cr-based alloy magnetic powder (A) and a thermosetting resin (B), in which a content of Cr contained in the component (A) is 0.1% by mass or more and 6% by mass or less relative to 100% by mass of the component (A). According to such a resin composition, the melt viscosity can be lowered, the relative magnetic permeability of the cured product of the resin composition can be increased, and the magnetic loss can be lowered.

The present inventor conjectures that the mechanism by which such excellent effects can be obtained by the resin composition according to the present embodiment is as described below. In general, an FeNi alloy, which has a crystal structure formed of Fe and Ni, has high crystallizability. Therefore, an FeNi alloy tends to have a high magnetic loss while having a high relative magnetic permeability. In contrast to this, when Si and Cr are introduced into an FeNi alloy, the crystal structure of Fe and Ni is distorted. Therefore, it was predicted that since the distortion of the crystal structure of Fe and Ni increases as the introduction amounts of Si and Cr increase, the relative magnetic permeability and magnetic loss sharply decrease. However, through studies by the present inventor, it became clear that introduction of Si can make the amount of decrease in magnetic loss larger. In addition, although introduction of Cr into an FeNi alloy has been considered to adversely affect a relative magnetic permeability, studies by the present inventor demonstrated that when the amount of Cr falls within a specific range of 0.1% by mass or more to 6% by mass or less, the melt viscosity can be lowered. Therefore, the Fe-Ni-Si-Cr-based alloy magnetic powder (A) containing Si and Cr in amounts within the above-mentioned specific ranges can exert, through Si, the unique effect of effectively decreasing the magnetic loss while exerting a high relative magnetic permeability through the crystal structure of Fe and Ni and also can lower the melt viscosity. Therefore, as compared to a known resin composition containing a magnetic powder, the cured product of the above-mentioned resin composition can lower the melt viscosity while maintaining the relative magnetic permeability and magnetic loss, because of the above-mentioned unique effect of the Fe-Ni-Si-Cr-based alloy magnetic powder (A).

However, the technical scope of the present invention is not limited by the above-mentioned mechanism. Furthermore, although a case in which Si and Cr are introduced into an FeNi alloy has been illustrated as an example in the above-mentioned description regarding the mechanism, the method for producing the Fe-Ni-Si-Cr-based alloy magnetic powder (A) is not particularly limited. Thus, those produced by methods other than the method of introducing Si and Cr into an FeNi alloy are also included in the Fe-Ni-Si-Cr-based alloy magnetic powder (A).

### <Fe-Ni-Si-Cr-based alloy magnetic powder (A)>

The resin composition includes an Fe-Ni-Si-Cr-based alloy magnetic powder (A) as the component (A). Therefore, the Fe-Ni-Si-Cr-based alloy magnetic powder (A) contains a combination of Fe, Ni, Si, and Cr.

The content of Cr contained in the Fe-Ni-Si-Cr-based alloy magnetic powder (A) is 0.1% by mass or more, preferably 0.5% by mass or more, and further preferably 1% by mass or more, relative to 100% by mass of the Fe-Ni-Si-Cr-based alloy magnetic powder (A). The upper limit is 6% by mass or less, preferably 5.5% by mass or less, and further preferably 4% by mass or less. When the Cr amount falls within the above-mentioned range, the melt viscosity of the resin composition can be lowered while increasing the relative magnetic permeability and lowering the magnetic loss of the cured product of the resin composition in a well-balanced manner.

The content of Si contained in the Fe-Ni-Si-Cr-based alloy magnetic powder (A) is preferably 0.1% by mass or more, preferably 0.15% by mass or more, and more preferably 0.2% by mass or more, and is preferably 5% by mass or less, more preferably 4% by mass or less, and further preferably 3% by mass or less, relative to 100% by mass of the Fe-Ni-Si-Cr-based alloy magnetic powder (A). When the amount of Si falls within the above-mentioned range, the melt viscosity of the resin composition can be lowered while increasing the relative magnetic permeability and lowering the magnetic loss of the cured product of the resin composition in a well-balanced manner.

The mass ratio (Si/Fe) between the Si amount and the Fe amount contained in the Fe-Ni-Si-Cr-based alloy magnetic powder (A) is preferably 0.01 or more, more preferably 0.02 or more, and particularly preferably 0.04 or more, and is preferably 0.17 or less, more preferably 0.16 or less, and particularly preferably 0.14 or less. When the ratio (Si/Fe) between the Si amount and the Fe amount falls within the above-mentioned range, the relative magnetic permeability and magnetic loss of the cured product of the resin composition can be effectively improved.

The mass ratio (Si/Ni) between the Si amount and the Ni amount in the Fe-Ni-Si-Cr-based alloy magnetic powder (A) is preferably 0.01 or more, more preferably 0.02 or more, and particularly preferably 0.04 or more, and is preferably 0.21 or less, more preferably 0.20 or less, and particularly preferably 0.18 or less. When the ratio (Si/Ni) between the Si amount and the Ni amount falls within the above-mentioned range, the relative magnetic permeability and magnetic loss of the cured product of the resin composition can be effectively improved.

The mass ratio (Cr/Fe) between the Cr amount and the Fe amount in the Fe-Ni-Si-Cr-based alloy magnetic powder (A) is preferably 0.01 or more, more preferably 0.02 or more, and particularly preferably 0.04 or more, and is preferably 0.17 or less, more preferably 0.16 or less, and particularly preferably 0.14 or less. When the ratio (Cr/Fe) between the Cr amount and the Fe amount falls within the above-mentioned range, the melt viscosity of the resin composition can be lowered, and the relative magnetic permeability and magnetic loss of the cured product of the resin composition can be effectively improved.

The mass ratio (Cr/Ni) between the Cr amount and the Ni amount in the Fe-Ni-Si-Cr-based alloy magnetic powder (A) is preferably 0.01 or more, more preferably 0.02 or more, and particularly preferably 0.04 or more, and is preferably 0.21 or less, more preferably 0.20 or less, and particularly preferably 0.18 or less. When the ratio (Cr/Ni) between the Cr amount and the Ni amount falls within the above-mentioned range, the melt viscosity of the resin composition can be lowered, and the relative magnetic permeability and magnetic loss of the cured product of the resin composition can be effectively improved.

The Fe amount contained in the Fe-Ni-Si-Cr-based alloy magnetic powder (A) is preferably 33.00% by mass or more, more preferably 38.00% by mass or more, further preferably 43.00% by mass or more, and particularly preferably 48.00% by mass or more, and is preferably 65.00% by mass or less, more preferably 60.00% by mass or less, further preferably 55.00% by mass or less, and particularly preferably 52.00% by mass or less, relative to 100% by mass of the Fe-Ni-Si-Cr-based alloy magnetic powder (A). When the Fe amount falls within the above-mentioned range, the relative magnetic permeability and magnetic loss of the cured product of the resin composition can be effectively improved.

The amount of Ni contained in the Fe-Ni-Si-Cr-based alloy magnetic powder (A) is preferably 33.00% by mass or more, more preferably 38.00% by mass or more, further preferably 40.00% by mass or more, and particularly preferably 42.00% by mass or more, and is preferably 65.00% by mass or less, more preferably 60.00% by mass or less, further preferably 54.00% by mass or less, and particularly preferably 49.00% by mass or less, relative to 100% by mass of the Fe-Ni-Si-Cr-based alloy magnetic powder (A). When the Ni amount falls within the above-mentioned range, the relative magnetic permeability and magnetic loss of the cured product of the resin composition can be effectively improved.

The total amount of Fe and Ni contained in the Fe-Ni-Si-Cr-based alloy magnetic powder (A) is preferably 85% by mass or more, more preferably 87% by mass or more, and particularly preferably 92% by mass or more, and is preferably 99% by mass or less, more preferably 98.5% by mass or less, and particularly preferably 98% by mass or less, relative to 100% by mass of the Fe-Ni-Si-based alloy magnetic powder (A). When the total amount of Fe and Ni falls within the above-mentioned range, the relative magnetic permeability and magnetic loss of the cured product of the resin composition can be effectively improved.

The mass ratio (Fe/Ni) between the Fe amount and the Ni amount contained in the Fe-Ni-Si-Cr-based alloy magnetic powder (A) is preferably 0.5 or more, more preferably 0.7 or more, and particularly preferably 1.0 or more, and is preferably 1.21 or less, more preferably 1.20 or less, and particularly preferably 1.19 or less. When the ratio (Fe/Ni) between the Fe amount and the Ni amount falls within the above-mentioned range, the relative magnetic permeability and magnetic loss of the cured product of the resin composition can be effectively improved.

The Fe-Ni-Si-Cr-based alloy magnetic powder (A) may contain an optional element other than Fe, Ni, Si, and Cr. Examples of the optional element may include elements derived from impurities that can be inevitably mixed in the method for producing the Fe-Ni-Si-Cr-based alloy magnetic powder (A). Specific examples of the optional element may include P, S, Mn, Mo, Cu, and Co. However, from the viewpoint of significantly exerting the effects of the present invention, the Fe-Ni-Si-Cr-based alloy magnetic powder (A) preferably does not contain an optional element other than Fe, Ni, Si, and Cr. Therefore, the Fe-Ni-Si-Cr-based alloy magnetic powder (A) preferably contains only Fe, Ni, Si, and Cr.

The amounts of Fe, Ni, Si, and Cr contained in the Fe-Ni-Si-Cr-based alloy magnetic powder (A) can be measured by an inductively coupled plasma emission spectroscopic analyzer (for example, "ICP-OES 720ES" manufactured by Agilent Technologies Inc.).

The average particle diameter (D50) of the Fe-Ni-Si-Cr-based alloy magnetic powder (A) is preferably 1 µm or more, more preferably 2 µm or more, and particularly preferably 3 µm or more. The average particle diameter (D50) of the Fe-Ni-Si-Cr-based alloy magnetic powder (A) being equal to or more than the above-mentioned lower limit value is preferable in terms of safety in handling the Fe-Ni-Si-Cr-based alloy magnetic powder (A). Furthermore, when the average particle diameter (D50) of the Fe-Ni-Si-Cr-based alloy magnetic powder (A) is equal to or more than the above-mentioned lower limit value, the Fe-Ni-Si-Cr-based alloy magnetic powder (A) and the resin component containing the thermosetting resin (B) can be mixed to be highly uniform. As a result, uneven distribution of the Fe-Ni-Si-Cr-based alloy magnetic powder (A) caused by aggregation can be effectively suppressed. Therefore, the relative magnetic permeability and magnetic loss of the cured product can be effectively improved. The upper limit of the average particle diameter (D50) of the Fe-Ni-Si-Cr-based alloy magnetic powder (A) is preferably 10 µm or less, more preferably 9 µm or less, and particularly preferably 7 µm or less. When the average particle diameter (D50) of the Fe-Ni-Si-Cr-based alloy magnetic powder (A) is equal to or less than the above-mentioned upper limit value, particles of the Fe-Ni-Si-Cr-based alloy magnetic powder (A) can be made small. Since the occurrence of a large eddy current loss caused by giant particles can be suppressed, the magnetic loss can be effectively suppressed. This effect is particularly effective when the amount of the Fe-Ni-Si-Cr-based alloy magnetic powder (A) is large.

The average particle diameter (D50) of the Fe-Ni-Si-Cr-based alloy magnetic powder (A) denotes the volume-based median diameter unless otherwise stated. This average particle diameter (D50) can be measured by a laser diffraction and scattering method based on the Mie scattering theory. Specifically, the average particle diameter (D50) can be measured by preparing a volume-based particle diameter distribution using a laser diffraction and scattering particle diameter distribution measuring device and defining its median diameter as the average particle diameter (D50). As a measurement sample, a powder dispersed in water by ultrasonic waves can be preferably used. As the laser diffraction and scattering particle diameter measuring device, an "LA-500" manufactured by Horiba, Ltd., a "SALD-2200" manufactured by Shimadzu Corporation, and the like can be used.

The specific surface area of the Fe-Ni-Si-Cr-based alloy magnetic powder (A) is preferably 0.05 m²/g or more, more preferably 0.1 m²/g or more, and further preferably 0.5 m²/g or more, and is preferably 20 m²/g or less, more preferably 10 m²/g or less, and further preferably 5 m²/g or less. When the specific surface area of the Fe-Ni-Si-Cr-based alloy magnetic powder (A) falls within the above-mentioned range, the melt viscosity of the resin composition can be lowered, and the relative magnetic permeability and magnetic loss of the cured product of the resin composition can be effectively improved. The specific surface area of the magnetic powder can be measured by a BET method. Specifically, the specific surface area can be measured in accordance with a BET method by allowing the sample surface to adsorb nitrogen gas using a specific surface area measuring device ("Macsorb HM Model 1210" manufactured by Mountech Co., Ltd.) and using a BET multi-point method.

The particles of the Fe-Ni-Si-Cr-based alloy magnetic powder (A) are preferably spherical. According to studies by the present inventor, particles of the Fe-Ni-Si-Cr-based alloy magnetic powder (A) containing Si can usually have a shape in which the surface is less uneven compared to particles of an FeNi alloy powder that does not contain Si and Cr, and therefore the former can have a shape close to a sphere.

A value (aspect ratio) obtained by dividing the major axis length of particles of the Fe-Ni-Si-Cr-based alloy magnetic powder (A) by the minor axis length is preferably 2 or less, more preferably 1.6 or less, and further preferably 1.4 or less. When the aspect ratio of the Fe-Ni-Si-Cr-based alloy magnetic powder (A) falls within the above-mentioned range, the magnetic loss can be suppressed, and the melt viscosity of the resin composition can be lowered.

The method for producing the Fe-Ni-Si-Cr-based alloy magnetic powder (A) is not particularly limited. The Fe-Ni-Si-Cr-based alloy magnetic powder (A) can be produced by, for example, an atomization method. In this atomization method, the Fe-Ni-Si-Cr-based alloy magnetic powder (A) is usually obtained by a method of spraying high pressure water or gas while dropping bath hot water containing dissolved iron, nickel, Si, and Cr, to thereby quench and solidify the materials. It is particularly preferable that the atomization method be a water atomization method of spraying water toward the falling bath hot water. As such an atomization method, the method disclosed in Japanese Patent Application Laid-Open No. 2018-178254 A, for example, can be adopted.

The content (% by volume) of the Fe-Ni-Si-Cr-based alloy magnetic powder (A) is preferably 30% by volume or more, more preferably 40% by volume or more, and particularly preferably 50% by volume or more, and is preferably 90% by volume or less, more preferably 80% by volume or less, and particularly preferably 70% by volume or less, relative to 100% by volume of the non-volatile components contained in the resin composition. When the amount of the Fe-Ni-Si-Cr-based alloy magnetic powder (A) falls within the above-mentioned range, the relative magnetic permeability and magnetic loss of the cured product of the resin composition can be effectively improved. When the amount of the Fe-Ni-Si-Cr-based alloy magnetic powder (A) is equal to or less than the upper limit value of the above-mentioned range, the melt viscosity of the resin composition can usually be effectively lowered to easily achieve a paste form.

The volume-based amount (% by volume) of each component contained in the resin composition is calculated from the mass of the component contained in the resin composition. Specifically, the volume of each component obtained by dividing the mass by the specific gravity can be used to calculate the volume-based amount (% by volume).

The content (% by mass) of the Fe-Ni-Si-Cr-based alloy magnetic powder (A) is preferably 40% by mass or more, more preferably 50% by mass or more, and particularly preferably 55% by mass or more, and is preferably 95% by mass or less, more preferably 90% by mass or less, and particularly preferably 85% by mass or less, relative to 100% by mass of the non-volatile component contained in the resin composition. When the amount of the Fe-Ni-Si-Cr-based alloy magnetic powder (A) falls within the above-mentioned range, the relative magnetic permeability and magnetic loss of the cured product of the resin composition can be effectively improved. When the amount of the Fe-Ni-Si-Cr-based alloy magnetic powder (A) is equal to or less than the upper limit value of the above-mentioned range, the melt viscosity of the resin composition can usually be effectively lowered to easily achieve a paste form.

The total amount of the magnetic powder contained in the resin composition is usually represented by the total amount of the Fe-Ni-Si-Cr-based alloy magnetic powder (A) and a later-described optional magnetic powder (C). The total amount (% by volume) of the magnetic powder contained in this resin composition is preferably 50% by volume or more, more preferably 60% by volume or more, further preferably 65% by volume or more, and particularly preferably 70% by volume or more, and is preferably 90% by volume or less, more preferably 86% by volume or less, and particularly preferably 82% by volume or less, relative to 100% by volume of the non-volatile components in the resin composition. When the total amount of the magnetic powder falls within the above-mentioned range, the relative magnetic permeability and magnetic loss of the cured product of the resin composition can be effectively improved. Furthermore, when the total amount of the magnetic powder is equal to or less than the upper limit value of the above-mentioned range, the melt viscosity of the resin composition can usually be effectively lowered to easily achieve a paste form.

The total amount of the magnetic powder contained in the resin composition is usually represented by the total amount of the Fe-Ni-Si-Cr-based alloy magnetic powder (A) and the later-described optional magnetic powder (C). The total amount (% by mass) of the magnetic powder contained in this resin composition is preferably 70% by mass or more, more preferably 80% by mass or more, further preferably 85% by mass or more, and particularly preferably 90% by mass or more, and is preferably 99% by mass or less, more preferably 98% by mass or less, and particularly preferably 97% by mass or less, relative to 100% by mass of the non-volatile component. When the total amount of the magnetic powder falls within the above-mentioned range, the relative magnetic permeability and magnetic loss of the cured product of the resin composition can be effectively improved. Furthermore, when the total amount of the magnetic powder is equal to or less than the upper limit value of the above-mentioned range, the melt viscosity of the resin composition can usually be effectively lowered to easily achieve a paste form.

### <(B) Thermosetting resin>

The resin composition includes a thermosetting resin (B) as the component (B). In general, the thermosetting resin (B) can bind a magnetic powder such as the Fe-Ni-Si-Cr-based alloy magnetic powder (A). In addition, the thermosetting resin (B) is usually capable of reacting with heat to cause bonding and curing. Therefore, a cured product can be obtained by curing a resin composition including the Fe-Ni-Si-Cr-based alloy magnetic powder (A) and the thermosetting resin (B) in combination. Since the cured product is excellent in terms of relative magnetic permeability and magnetic loss, an excellent magnetic layer can be formed.

Examples of the thermosetting resin (B) may include an epoxy resin, a phenol-based resin, an active ester-based resin, an amine-based resin, an acid anhydride-based resin, a benzoxazine-based resin, a cyanate ester-based resin, and a carbodiimide-based resin. As the thermosetting resin (B), one type thereof may be solely used, and two or more types thereof may also be used in combination.

The thermosetting resin (B) preferably includes an epoxy resin (B-1). The epoxy resin (B-1) represents a resin having one or more epoxy groups within one molecule. When the thermosetting resin (B) contains the epoxy resin (B-1), the dispersibility of the Fe-Ni-Si-Cr-based alloy magnetic powder (A) can be enhanced, and the relative magnetic permeability and magnetic loss of the cured product of the resin composition can be effectively improved.

Examples of the epoxy resin (B-1) may include a bixylenol type epoxy resin, a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenol novolac type epoxy resin; a glycidyl amine type epoxy resin; a glycidyl ester type epoxy resin; a cresol novolac type epoxy resin; a biphenyl type epoxy resin; a linear aliphatic epoxy resin; an epoxy resin having a butadiene structure; an alicyclic epoxy resin; an alicyclic epoxy resin having an ester skeleton; a heterocyclic epoxy resin; a spirocyclic ring-containing epoxy resin; a cyclohexane type epoxy resin; a cyclohexanedimethanol type epoxy resin; a trimethylol type epoxy resin; a tetraphenylethane type epoxy resin; an epoxy resin having a condensed ring skeleton such as a naphthylene ether type epoxy resin, a tert-butyl-catechol type epoxy resin, a naphthalene type epoxy resin, a naphthol type epoxy resin, an anthracene type epoxy resin, and a naphthol novolac type epoxy resin; an isocyanurate type epoxy resin; an alkyleneoxy skeleton- and butadiene skeleton-containing epoxy resin; and a fluorene structure-containing epoxy resin. As the epoxy resin (B-1), one type thereof may be solely used, and two or more types thereof may also be used in combination.

The epoxy resin (B-1) preferably includes an epoxy resin having two or more epoxy groups within one molecule. The proportion of the epoxy resin having two or more epoxy groups within one molecule relative to 100% by mass of the total amount of the epoxy resin (B-1) is preferably 50% by mass or more, more preferably 60% by mass or more, and particularly preferably 70% by mass or more.

The epoxy resin (B-1) preferably has an aromatic structure. When two or more types of epoxy resins are used, it is preferable that one or more types of epoxy resins have an aromatic structure. Aromatic structures are chemical structures that are generally defined as aromatic and also include polycyclic aromatic and aromatic heterocyclic rings.

The epoxy resin (B-1) may be classified into epoxy resins in a liquid state at a temperature of 20°C (hereinafter may be referred to as a "liquid epoxy resin") and epoxy resins in a solid state at a temperature of 20°C (hereinafter may be referred to as a "solid epoxy resin"). The epoxy resin (B-1) may be a liquid epoxy resin alone, a solid epoxy resin alone, or a combination of a liquid epoxy resin and a solid epoxy resin. Among these, the epoxy resin (B-1) preferably contains a liquid epoxy resin, and particularly preferably contains only a liquid epoxy resin.

The liquid epoxy resin is preferably a liquid epoxy resin having two or more epoxy groups within one molecule. Examples of preferable liquid epoxy resins may include a bisphenol A type epoxy resin, a bisphenol F type epoxy resin, a bisphenol AF type epoxy resin, a naphthalene type epoxy resin, a glycidyl ester type epoxy resin, a glycidyl amine type epoxy resin, a phenol novolac type epoxy resin, an alicyclic epoxy resin having an ester skeleton, a cyclohexane type epoxy resin, a cyclohexane dimethanol type epoxy resin, an epoxy resins having a butadiene structure, an epoxy resin containing an alkyleneoxy skeleton and a butadiene skeleton, an epoxy resin containing a fluorene structure, and a dicyclopentadiene type epoxy resin. Among these, a bisphenol A type epoxy resin and a bisphenol F type epoxy resin are particularly preferable.

Specific examples of the liquid epoxy resins may include "YX7400" manufactured by Mitsubishi Chemical Corporation; "HP4032", "HP4032D", and "HP4032SS" (naphthalene type epoxy resin) that are manufactured by DIC Corp.; "828US", "828EL", "jER828EL", "825", and "Epicoat 828EL" (bisphenol A type epoxy resin) that are manufactured by Mitsubishi Chemical Corporation; "jER807" and "1750" (bisphenol F type epoxy resin) that are manufactured by Mitsubishi Chemical Corporation; "jER152" (phenol novolac type epoxy resin) manufactured by Mitsubishi Chemical Corporation; "630", "630LSD", and "604" (glycidyl amine type epoxy resin) that are manufactured by Mitsubishi Chemical Corporation; "ED-523T" (glycylol type epoxy resin) manufactured by ADEKA Corporation; "EP-3950L" and "EP-3980S" (glycidyl amine type epoxy resin) manufactured by ADEKA Corporation; "EP-4088S" (dicyclopentadiene type epoxy resin) manufactured by ADEKA Corporation; "ZX-1059"(mixed product of bisphenol A type epoxy resin and bisphenol F type epoxy resin) manufactured by NIPPON STEEL Chemical & Material Co., Ltd.; "EX-721" (glycidyl ester type epoxy resin) manufactured by Nagase ChemteX Corp.; "EX-991L" (alkyleneoxy skeleton-containing epoxy resin) manufactured by Nagase ChemteX Corp.; "celloxide 2021P" and "celloxide 2081" (alicyclic epoxy resin having an ester skeleton) that are manufactured by Daicel Corp.; "PB-3600" manufactured by Daicel Corp., "JP-100" and "JP-200" (epoxy resin having a butadiene structure) that are manufactured by Nippon Soda Co., Ltd.; "ZX-1658" and "ZX-1658GS" (liquid 1,4-glycidyl cyclohexane type epoxy resin) that are manufactured by NIPPON STEEL Chemical & Material Co., Ltd.; and "EG-280" (fluorene structure-containing epoxy resin) manufactured by Osaka Gas Chemicals Co., Ltd. As these liquid epoxy resins, one type thereof may be solely used, and two or more types thereof may also be used in combination.

As the solid epoxy resin, a solid epoxy resin having three or more epoxy groups within one molecule is preferable, and an aromatic solid epoxy resin having three or more epoxy groups within one molecule is more preferable. As the solid epoxy resin, a bixylenol type epoxy resin, a naphthalene type epoxy resin, a naphthalene type tetrafunctional epoxy resin, a cresol novolac type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, a bisphenol AF type epoxy resin, and a tetraphenylethane type epoxy resin are preferable, and a dicyclopentadiene type epoxy resin is particularly preferable.

Specific examples of the solid epoxy resin may include "HP4032H" (naphthalene type epoxy resin) manufactured by DIC Corp.; "HP-4700" and "HP-4710" (naphthalene type tetrafunctional epoxy resin) that are manufactured by DIC Corp.; "N-690" (cresol novolac type epoxy resin) manufactured by DIC Corp.; "N-695" (cresol novolac type epoxy resin) manufactured by DIC Corp.; "HP-7200", "HP-7200HH", and "HP-7200H" (dicyclopentadiene type epoxy resin) that are manufactured by DIC Corp.;, "EXA-7311", "EXA-7311-G3", "EXA-7311-G4", "EXA-7311-G4S", and "HP6000" (naphthylene ether type epoxy resin) that are manufactured by DIC Corp.; "EPPN-502H" (trisphenol type epoxy resin) manufactured by Nippon Kayaku Co., Ltd.; "NC7000L" (naphthol novolac type epoxy resin) manufactured by Nippon Kayaku Co., Ltd.; "NC3000H", "NC3000", "NC3000L", and "NC3100" (biphenyl type epoxy resin) that are manufactured by Nippon Kayaku Co., Ltd.; "ESN475V" (naphthol type epoxy resin) manufactured by NIPPON STEEL Chemical & Material Co., Ltd.; "ESN485" (naphthol novolac type epoxy resin) manufactured by NIPPON STEEL Chemical & Material Co., Ltd.; "YX4000H", "YX4000" and "YL6121" (biphenyl type epoxy resin) that are manufactured by Mitsubishi Chemical Corporation; "YX4000HK" (bixylenol type epoxy resin) manufactured by Mitsubishi Chemical Corporation; "YX8800" (anthracene type epoxy resin) manufactured by Mitsubishi Chemical Corporation; "YX7700" (xylene structure-containing novolac type epoxy resin) manufactured by Mitsubishi Chemical Corporation; "PG-100" and "CG-500" that are manufactured by Osaka Gas Chemical Co.; "YL7760" (bisphenol AF type epoxy resin) manufactured by Mitsubishi Chemical Corporation; "YL7800" (fluorene type epoxy resin) manufactured by Mitsubishi Chemical Corporation; "jER1010" (solid bisphenol A type epoxy resin) manufactured by Mitsubishi Chemical Corporation; and "jER1031S" (tetraphenylethane type epoxy resin) manufactured by Mitsubishi Chemical Corporation. As these solid epoxy resins, one type thereof may be solely used, and two or more types thereof may also be used in combination.

As an epoxy resin, when used in combination with a liquid epoxy resin and a solid epoxy resin, the mass ratio between the liquid epoxy resin and the solid epoxy resin (liquid epoxy resin / solid epoxy resin) is preferably 0.5 or more, more preferably 1 or more, further preferably 5 or more, particularly preferably 10 or more.

The epoxy equivalent of the epoxy resin (B-1) is preferably 50 g/eq. to 5,000 g/eq., more preferably 50 g/eq. to 3,000 g/eq., further preferably 80 g/eq. to 2,000 g/eq., and still further preferably 110 g/eq. to 1,000 g/eq. The epoxy equivalent is the mass of a resin containing one equivalent of epoxy groups. The epoxy equivalent can be measured in accordance with JIS K7236.

The weight-average molecular weight (Mw) of the epoxy resin (B-1) is preferably 100 to 5,000, more preferably 250 to 3,000, and further preferably 400 to 1,500. The weight-average molecular weight of the resin can be measured as a polystyrene-equivalent value by a gel permeation chromatography (GPC) method.

The amount (% by mass) of the epoxy resin (B-1) contained in the resin composition is preferably 0.1% by mass or more, more preferably 0.5% by mass or more, and particularly preferably 1% by mass or more, and is preferably 10% by mass or less, more preferably 5% by mass or less, and particularly preferably 3% by mass or less, relative to 100% by mass of the non-volatile components of the resin composition. When the amount of the epoxy resin (B-1) falls within the above-mentioned range, the melt viscosity of the resin composition can be lowered, and the relative magnetic permeability and magnetic loss of the cured product of the resin composition can be effectively improved.

The amount (% by mass) of the epoxy resin (B-1) contained in the resin composition is preferably 20% by mass or more, more preferably 30% by mass or more, and particularly preferably 40% by mass or more, and is preferably 90% by mass or less, more preferably 80% by mass or less, and particularly preferably 70% by mass or less, relative to 100% by mass of the resin component of the resin composition. When the amount of the epoxy resin (B-1) falls within the above-mentioned range, the melt viscosity of the resin composition can be lowered, and the relative magnetic permeability and magnetic loss of the cured product of the resin composition can be effectively improved.

When the thermosetting resin (B) includes the epoxy resin (B-1), the thermosetting resin (B) may include a resin capable of reacting with and bonding to the epoxy resin (B-1). A resin capable of reacting with and bonding to the epoxy resin (B-1) is hereinafter sometimes referred to as a "curing agent (B-2)". Examples of the curing agent (B-2) may include a phenol-based resin, an active ester-based resin, an amine-based resin, a carbodiimide-based resin, an acid anhydride-based resin, a benzoxazine-based resin, a cyanate ester-based resin, and a thiol-based resin. As the curing agent (B-2), one type thereof may be solely used, and two or more types thereof may also be used in combination. Among these, a phenol-based resin is preferable.

As the phenol-based resin, a resin having one or more, preferably two or more, hydroxyl groups bonded to an aromatic ring such as a benzene ring or a naphthalene ring within one molecule, may be used. From the viewpoint of heat resistance and water resistance, a phenol-based resin having a novolac structure is preferable. From the viewpoint of adhesion, a nitrogen-containing phenol-based resin is preferable, and a triazine skeleton-containing phenol-based resin is more preferable. Among these, a triazine skeleton-containing phenol novolac resin is preferable from the viewpoint of highly satisfying heat resistance, water resistance, and adhesion.

Specific examples of the phenol-based resin may include "MEH-7700", "MEH-7810", "MEH-7851" and "MEH-8000H" that are manufactured by Meiwa Plastic Industries, Ltd.; "NHN", "CBN", and "GPH" that are manufactured by Nippon Kayaku Co., Ltd., "SN-170", "SN-180", "SN-190", "SN-475", "SN-485", "SN-495", "SN-495V", "SN-375", and "SN-395" manufactured by Nippon Steel Chemical & Material Co., Ltd.; "TD-2090", "TD-2090", "TD-2090-60M", "LA-7052", "LA-7054", "LA-1356", "LA-3018", "LA-3018-50P", "EXB-9500", "HPC-9500", "KA-1160", "KA-1163", and "KA-1165" that are manufactured by DIC Corp., and "GDP-6115L", "GDP-6115H" and "ELPC75" manufactured by Gun Ei Chemical Industry Co., Ltd.

As the active ester-based resin, a compound having one or more, preferably two or more, active ester groups within one molecule may be used. Among these, the active ester-based resin is preferably a compound having two or more highly reactive ester groups within one molecule, such as phenol esters, thiophenol esters, N-hydroxyamine esters, and esters of heterocyclic hydroxy compounds. The active ester resin is preferably obtained by performing a condensation reaction of a carboxylic acid compound and/or a thiocarboxylic acid compound with a hydroxy compound and/or a thiol compound. In particular, from the viewpoint of improving heat resistance, an active ester-based resin obtained from a carboxylic acid compound and a hydroxy compound is preferable, and an active ester-based resin obtained from a carboxylic acid compound and a phenol compound and/or a naphthol compound is more preferable. Examples of the carboxylic acid compound may include benzoic acid, acetic acid, succinic acid, maleic acid, itaconic acid, phthalic acid, isophthalic acid, terephthalic acid, and pyromellitic acid. Examples of the phenol compound or naphthol compound may include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, a dicyclopentadiene type diphenol compound, and phenol novolac. Here, the "dicyclopentadiene-type diphenol compound" refers to a diphenol compound obtained by condensing two phenol molecules into one dicyclopentadiene molecule.

Preferable specific examples of the active ester-based resin may include an active ester-based resin containing a dicyclopentadiene type diphenol structure, an active ester-based resin containing a naphthalene structure, an active ester-based resin containing an acetylated product of phenol novolac, and an active ester-based resin containing a benzoylated product of phenol novolac. Among these, an active ester-based resin containing a naphthalene structure and an active ester-based resin containing a dicyclopentadiene type diphenol structure are more preferable. The "dicyclopentadiene type diphenol structure" refers to a divalent structural unit consisting of phenylene-dicyclopentylene-phenylene.

Examples of the commercially available active ester-based resin may include "EXB9451", "EXB9460", "EXB9460S", "HPC-8000-65T", "HPC-8000H-65TM" and "EXB-8000L-65TM" (manufactured by DIC Corp.) as an active ester-based resin containing a dicyclopentadiene type diphenol structure; "EXB-9416-70BK", "EXB-8150-65T", "EXB-8100L-65T" and "EXB-8150L-65T" (manufactured by DIC Corp.) as an active ester-based resin containing a naphthalene structure; "DC808" (manufactured by Mitsubishi Chemical Corporation) as an active ester-based resin containing an acetylated product of phenol novolac; "YLH1026" (manufactured by Mitsubishi Chemical Corporation) as an active ester-based resin containing a benzoylated product of phenol novolac; "DC808" (manufactured by Mitsubishi Chemical Corporation) as an active ester-based resin which is an acetylated product of phenol novolac; "YLH1026" (manufactured by Mitsubishi Chemical Corporation), "YLH1030" (manufactured by Mitsubishi Chemical Corporation), and "YLH1048" (manufactured by Mitsubishi Chemical Corporation) as an active ester-based resin which is a benzoylated product of phenol novolac.

As the amine-based resin, a resin having one or more, preferably two or more, amino groups within one molecule may be used. Examples of the amine-based resin may include aliphatic amines, polyether amines, alicyclic amines, and aromatic amines. Among these, aromatic amines are preferable. The amine-based resin is preferably a primary amine or a secondary amine, and more preferably a primary amine. Specific examples of the amine-based resin may include 4,4'-methylenebis(2,6-dimethylaniline), diphenyldiaminosulfone, 4,4'-diaminodiphenylmethane, 4,4'-diaminodiphenylsulfone, 3,3'-diaminodiphenylsulfone, m-phenylenediamine, m-xylylenediamine, diethyltoluenediamine, 4,4'-diaminodiphenylether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethanediamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl)sulfone, and bis(4-(3-aminophenoxy)phenyl)sulfone. A commercially available amine-based resin may be used, for example, such as "KAYABOND C-200S", "KAYABOND C-100", "Kayahard A-A", "Kayahard A-B", and "Kayahard A-S" that are manufactured by Nippon Kayaku Co., Ltd., and "Epicure W" manufactured by Mitsubishi Chemical Corporation.

As the carbodiimide-based resin, a resin having one or more, preferably two or more, carbodiimide structures within one molecule may be used. Specific examples of the carbodiimide-based resin may include aliphatic biscarbodiimides such as tetramethylene-bis(t-butylcarbodiimide) and cyclohexane bis(methylene-t-butylcarbodiimide); biscarbodiimides such as aromatic biscarbodiimides e.g., phenylene-bis(xylylcarbodiimide) and the like; aliphatic polycarbodiimides such as polyhexamethylenecarbodiimide, polytrimethylhexamethylenecarbodiimide, polycyclohexylenecarbodiimide, poly(methylenebiscyclohexylenecarbodiimide), and poly(isophoronecarbodiimide); and polycarbodiimides such as aromatic polycarbodiimides, e.g., poly(phenylenecarbodiimide), poly(naphthylenecarbodiimide), poly(tolylenecarbodiimide), poly(methyldiisopropylphenylenecarbodiimide), poly(triethylphenylenecarbodiimide), poly(diethylphenylenecarbodiimide), poly(triisopropylphenylenecarbodiimide), poly(diisopropylphenylenecarbodiimide), poly(xylylenecarbodiimide), poly(tetramethylxylylenecarbodiimide), poly(methylenediphenylenecarbodiimide), and poly[methylenebis(methylphenylene)carbodiimide]. Examples of commercially available products of the carbodiimide-based resin may include "Carbodilite V-02B", "Carbodilite V-03", "Carbodilite V-04K", "Carbodilite V-07" and "Carbodilite V-09" that are manufactured by Nisshinbo Chemical Inc.; and "STABAXOL P", "STABAXOL P400" and "HYCAZIL 510" manufactured by Line Chemie.

As the acid anhydride-based resin, a resin having one or more acid anhydride groups within one molecule can be used, and a resin having two or more acid anhydride groups within one molecule is preferable. Specific examples of the acid anhydride-based resin may include phthalic anhydride, tetrahydrophthalic anhydride, hexahydrophthalic anhydride, methyltetrahydrophthalic anhydride, methylhexahydrophthalic anhydride, methylnadic anhydride, hydrogenated methylnadic anhydride, trialkyltetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphtho[1,2-C]furan-1,3-dione, ethylene glycol bis(anhydrotrimellitate), and polymeric acid anhydride such as styrene-maleic acid resin, which is a copolymer of styrene and maleic acid, etc. Examples of commercially available products of acid anhydride-based resins may include "HNA-100", "MH-700", "MTA-15", "DDSA" and "OSA" that are manufactured by New Japan Chemical Co., Ltd.; "YH-306" and "YH-307" that are manufactured by Mitsubishi Chemical Corporation; "HN-2200" and "HN-5500" that are manufactured by Hitachi Chemical Co., Ltd.; and "EF-30", "EF-40", "EF-60" and "EF-80" manufactured by Clay Valley Co., Ltd.

Specific examples of the benzoxazine-based resin may include "JBZ-OD100", "JBZ-OP100D", and "ODA-BOZ" that are manufactured by JFE Chemical Corporation; "P-d" and "F-a" that are manufactured by Shikoku Chemicals Corporation; and "HFB2006M" manufactured by Showa Highpolymer Co., Ltd.

Examples of the cyanate ester-based epoxy resin may include difunctional cyanate resins such as bisphenol A dicyanate, polyphenol cyanate, oligo(3-methylene-1,5-phenylene cyanate), 4,4'-methylenebis(2,6-dimethylphenyl cyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl)thioether, and bis(4-cyanatephenyl)ether; polyfunctional cyanate resins derived from phenol novolac, cresol novolac and the like; and prepolymers obtained by partially triazinizing these cyanate resins as above. Specific examples of the cyanate ester-based epoxy resin may include "PT30" and "PT60" (phenol novolac type polyfunctional cyanate ester resin), "ULL-950" (polyfunctional cyanate ester resin), and "BA230" and "BA230S75" (prepolymers in which part or all of bisphenol A dicyanate is triazinated to form a trimer), which are manufactured by LONZA K.K..

Examples of the thiol-based resin may include trimethylolpropane tris(3-mercaptopropionate), pentaerythritol tetrakis(3-mercaptobutyrate), and tris(3-mercaptopropyl)isocyanurate.

The active group equivalent of the curing agent (B-2) is preferably 50 g/eq. to 3,000 g/eq., more preferably 100 g/eq. to 1,000 g/eq., even more preferably 100 g/eq. to 500 g/eq., and particularly preferably 100 g/eq. to 300 g/eq. The active group equivalent represents the mass of the curing agent (B-2) per equivalent of active group.

When the number of epoxy groups in the epoxy resin (B-1) is set to 1, the number of active groups in the curing agent (B-2) is preferably 0.01 or more, more preferably 0.1 or more, and particularly preferably 0.5 or more, and is preferably 10 or less, more preferably 5 or less, and particularly preferably 3 or less. The active group of the curing agent (B-2) is an active hydroxyl group or the like, and varies depending on the type of the curing agent. The number of epoxy groups in the epoxy resin (B-1) is calculated by dividing the mass of non-volatile components of each epoxy resin by its epoxy equivalent and summing the resulting values for all epoxy resins. The number of active groups of the curing agent (B-2) is calculated by dividing the mass of non-volatile components of each curing agent by its active group equivalent and summing the resulting values for all curing agents.

The amount (% by mass) of the curing agent (B-2) contained in the resin composition is preferably 0.1% by mass or more, more preferably 0.5% by mass or more, and particularly preferably 1% by mass or more, and is preferably 10% by mass or less, more preferably 5% by mass or less, and particularly preferably 3% by mass or less, relative to 100% by mass of the non-volatile components of the resin composition. When the amount of the curing agent (B-2) falls within the above-mentioned range, the melt viscosity of the resin composition can be lowered, and the relative magnetic permeability and magnetic loss of the cured product of the resin composition can be effectively improved.

The amount (% by mass) of the curing agent (B-2) contained in the resin composition is preferably 10% by mass or more, more preferably 20% by mass or more, and particularly preferably 30% by mass or more, and is preferably 50% by mass or less, more preferably 45% by mass or less, and particularly preferably 40% by mass or less, relative to 100% by mass of the resin component of the resin composition. When the amount of the curing agent (B-2) falls within the above-mentioned range, the melt viscosity of the resin composition can be lowered, and the relative magnetic permeability and magnetic loss of the cured product of the resin composition can be effectively improved.

The range of the weight-average molecular weight (Mw) of the thermosetting resin (B) may be generally the same as the range of the weight-average molecular weight of the epoxy resin (B-1) described above.

The amount (% by mass) of the thermosetting resin (B) contained in the resin composition is preferably 0.1% by mass or more, more preferably 0.5% by mass or more, and particularly preferably 1% by mass or more, and is preferably 30% by mass or less, more preferably 20% by mass or less, and particularly preferably 10% by mass or less, relative to 100% by mass of the non-volatile components of the resin composition. When the amount of the thermosetting resin (B) falls within the above-mentioned range, the melt viscosity of the resin composition can be lowered, and the relative magnetic permeability and magnetic loss of the cured product of the resin composition can be effectively improved.

The amount (% by mass) of the thermosetting resin (B) contained in the resin composition is preferably 30% by mass or more, more preferably 50% by mass or more, and particularly preferably 60% by mass or more, and is preferably 99% by mass or less, more preferably 90% by mass or less, and particularly preferably 85% by mass or less, relative to 100% by mass of the resin component of the resin composition. When the amount of the thermosetting resin (B) falls within the above-mentioned range, the melt viscosity of the resin composition can be lowered, and the relative magnetic permeability and magnetic loss of the cured product of the resin composition can be effectively improved.

The total amount (% by mass) of the Fe-Ni-Si-Cr-based alloy magnetic powder (A) and the thermosetting resin (B) is preferably 50% by mass or more, more preferably 55% by mass or more, and particularly preferably 60% by mass or more, and is preferably 100% by mass or less, more preferably 95% by mass or less, particularly preferably 90% by mass or less, or 85% by mass or less, relative to 100% by mass of the non-volatile components of the resin composition. When the total amount of the Fe-Ni-Si-Cr-based alloy magnetic powder (A) and the thermosetting resin (B) falls within the above-mentioned range, the melt viscosity of the resin composition can be lowered, and the relative magnetic permeability and magnetic loss of the cured product of the resin composition can be effectively improved.

### <Optional magnetic powder (C) (magnetic powder other than Fe-Ni-Si-Cr-based alloy magnetic powder)>

The resin composition may further contain, as an optional component, a magnetic powder other than the Fe-Ni-Si-Cr-based alloy magnetic powder (C) in combination with the above-described components (A) to (B). The "magnetic powder other than the Fe-Ni-Si-Cr-based alloy magnetic powder (C)" as the component (C) may be referred to as "optional magnetic powder (C) " as appropriate.

As the optional magnetic powder (C), particles of a material having a relative magnetic permeability greater than 1 can be used. The material of the optional magnetic powder (C) is usually an inorganic material, may be a soft magnetic material, or may be a hard magnetic material. As the material of the optional magnetic powder (C), one type thereof may be solely used, and two or more types thereof may also be used in combination. Therefore, the optional magnetic powder (C) may be a soft magnetic powder, a hard magnetic powder, or a combination of a soft magnetic powder and a hard magnetic powder. As the optional magnetic powder (C), one type thereof may be solely used, and two or more types thereof may also be used in combination. Among these, the optional magnetic powder (C) preferably contains a soft magnetic powder, and more preferably contains only a soft magnetic powder.

Examples of the optional magnetic powder (C) may include a magnetic metal oxide powder and a magnetic metal powder.

Examples of the magnetic metal oxide powder may include a ferrite-based magnetic powder; and an iron oxide powder such as an iron oxide (III) powder and a triiron tetraoxide powder. Among these, a ferrite-based magnetic powder is preferable. Therefore, the optional magnetic powder (C) preferably includes a ferrite-based magnetic powder. In one example, as the optional magnetic powder (C), only a ferrite-based magnetic powder may be used. The ferrite-based magnetic powder is usually composed of a composite oxide containing iron oxide as a main component, and is chemically stable. Therefore, the ferrite-based magnetic powder offers advantageous effects such as high corrosion resistance, low risk of fire, and resistance to demagnetization.

Examples of the ferrite-based magnetic powder may include an Fe-Mn-based ferrite powder, an Fe-Mn-Zn-based ferrite powder, an Fe-Mn-Mg-based ferrite powder, an Fe-Mn-Mg-Sr-based ferrite powder, an Fe-Mg-Zn-based ferrite powder, an Fe-Mg-Sr-based ferrite powder, an Fe-Zn-Mn-based ferrite powder, an Fe-Cu-Zn-based ferrite powder, an Fe-Ni-Zn-based ferrite powder, an Fe-Ni-Zn-Cu-based ferrite powder, an Fe-Ba-Zn-based ferrite powder, an Fe-Ba-Mg-based ferrite powder, an Fe-Ba-Ni-based ferrite powder, an Fe-Ba-Co-based ferrite powder, an Fe-Ba-Ni-Co-based ferrite powder, and an Fe-Y-based ferrite powder.

Among the ferrite-based magnetic powders, ferrite-based magnetic powders containing at least one element selected from the group consisting of Mn, Zn, Ni, and Cu are preferable. Therefore, the optional magnetic powder (C) preferably contains a ferrite-based magnetic powder containing at least one element selected from the group consisting of Mn, Zn, Ni, and Cu. In one embodiment, as the optional magnetic powder (C), only a ferritic magnetic powder containing at least one element selected from the group consisting of Mn, Zn, Ni, and Cu may be used. Examples of such preferable ferrite-based magnetic powders may include an Fe-Mn-based ferrite powder, an Fe-Mn-Zn-based ferrite powder, an Fe-Mn-Mg-based ferrite powder, an Fe-Mn-Mg-Sr-based ferrite powder, an Fe-Mg-Zn-based ferrite powder, an Fe-Zn-Mn-based ferrite powder, an Fe-Cu-Zn-based ferrite powder, an Fe-Ni-Zn-based ferrite powder, an Fe-Ni-Zn-Cu-based ferrite powder, an Fe-Ba-Zn-based ferrite powder, an Fe-Ba-Ni-based ferrite powder, and an Fe-Ba-Ni-Co ferrite powder. Among these, a ferrite-based magnetic powder containing at least one element selected from the group consisting of Zn and Mn is more preferable, and a ferrite-based magnetic powder containing Zn and Mn is particularly preferable. Therefore, an Fe-Mn-Zn-based ferrite powder and an Fe-Mn-based ferrite powder are preferable as the ferrite-based magnetic powder, and an Fe-Mn-Zn-based ferrite powder is particularly preferable. "Fe-Zn-Mn-based ferrite powder" represents a ferrite powder containing Fe, Zn, and Mn, and "Fe-Mn-based ferrite powder" represents a ferrite powder containing Fe and Mn.

Examples of the magnetic metal powder may include a pure iron powder; and crystalline or amorphous alloy magnetic powders such as an Fe-Mn-Zn-based alloy powder, an Fe-Si-based alloy powder, an Fe-Mn-based alloy powder, an Fe-Si-Al-based alloy powder, an Fe-Cr-based alloy powder, an Fe-Cr-Si-based alloy powder, an Fe-Ni-Cr-based alloy powder, an Fe-Cr-Al-based alloy powder, an Fe-Ni-based alloy powder, an Fe-Ni-B-based alloy powder, an Fe-Ni-Mo-based alloy powder, an Fe-Ni-Mo-Cu-based alloy powder, an Fe-Co-based alloy powder, an Fe-Ni-Co-based alloy powder, a Co based amorphous alloy powder, and the like. Among these, an alloy magnetic powder other than the Fe-Ni-Si-Cr-based alloy magnetic powder is preferable. Therefore, it is preferable that the optional magnetic powder (C) contains an alloy magnetic powder other than the Fe-Ni-Si-Cr-based alloy magnetic powder. In one example, only an alloy magnetic powder other than the Fe-Ni-Si-Cr-based alloy magnetic powder may be used as the optional magnetic powder (C). Among the alloy magnetic powders, an iron alloy-based powder is more preferable.

As a particularly preferable magnetic metallic powder, an iron alloy-based magnetic powder containing Fe and at least one element selected from the group consisting of Si and Cr is preferable, and an Fe-Cr-Si-based alloy powder is particularly preferable. "Fe-Cr-Si-based alloy powder" represents an alloy powder containing Fe, Cr, and Si.

As the optional magnetic powder (C), a commercially available magnetic powder may be used. Specific examples of the commercially available magnetic powder may include: "MZ03S", "MOSS", "MOSS", "M001", and "MZ05S" that are manufactured by Powdertech; "PST-S" manufactured by Sanyo Special Steel Co., Ltd.; "AW2-08", "AW2-08PF20F", "AW2-08PF10F", "AW2-08PF3F", "Fe-3.5Si-4.5CrPF20F", "Fe-50NiPF20F", and "Fe-80Ni-4MoPF20F" that are manufactured by Epson Atmix Corp; "CVD Iron Powder 0.7 µm", "LD-M", "LD-MH", "KNI-106", "KNI-106GSM", "KNI-106GS", "KNI-109", "KNI-109GSM", and "KNI-109GS" that are manufactured by JFE Chemical Corp.; "KNS-415", "BSF-547", "BSF-029", "BSN-125", "BSN-714", "BSN-828", "S-1281", "S-1641", "S-1651", "S-1470", "S-1511", and "S-2430" that are manufactured by Toda Kogyo Corp.; "JR09P2" manufactured by Japan Metals & Chemicals Co., Ltd.; "Nanotek" manufactured by CIK-Nano Tek; "JEMK-S" and "JEMK-H" that are manufactured by Kinsei Matec Co., Ltd.; "Yttrium iron oxide" manufactured by Sigma-Aldrich; and "MA-RCO-5" manufactured by Dowa Electronics Materials Co., Ltd. As the optional magnetic powder (C), one type thereof may be solely used, and two or more types thereof may also be used in combination.

The optional magnetic powder (C) preferably has a smaller average particle diameter than that of the Fe-Ni-Si-Cr-based alloy magnetic powder (A). When the optional magnetic powder (C) has a smaller average particle diameter than that of the Fe-Ni-Si-Cr-based alloy magnetic powder (A), the optional magnetic powder (C) can enter the gap between the particles of the Fe-Ni-Si-Cr-based alloy magnetic powder (A). Thus, the magnetic powder can be densely filled, thereby improving the magnetic properties such as a relative magnetic permeability.

A ratio of the average particle diameter of the optional magnetic powder (C) to the average particle diameter of the Fe-Ni-Si-Cr-based alloy magnetic powder (A) (the average particle diameter of the optional magnetic powder (C) / the average particle diameter of the Fe-Ni-Si-Cr-based alloy magnetic powder (A)) preferably falls within a specified range. Specifically, the ratio (the average particle diameter of the optional magnetic powder (C) / the average particle diameter of the Fe-Ni-Si-Cr-based alloy magnetic powder (A)) is preferably 0.001 or more, more preferably 0.01 or more, and particularly preferably 0.05 or more, and is preferably 0.9 or less, more preferably 0.6 or less, and particularly preferably 0.3 or less. When the ratio (the average particle diameter of the optional magnetic powder (C) / the average particle diameter of the Fe-Ni-Si-Cr-based alloy magnetic powder (A)) falls within the above-mentioned range, the relative magnetic permeability and magnetic loss of the cured product of the resin composition can be effectively improved.

The specific range of the average particle diameter of the optional magnetic powder (C) is preferably 0.05 µm or more, more preferably 0.1 µm or more, and particularly preferably 0.2 µm or more, preferably 3 µm or less, more preferably 2 µm or less, and particularly preferably 1.5 µm or less. When the average particle diameter of the optional magnetic powder (C) is the above-mentioned lower limit value or more, the viscosity of the resin composition can be lowered. In addition, when the average particle diameter is the upper limit value or less, the relative magnetic permeability and magnetic loss of the cured product of the resin composition can be effectively improved.

The average particle diameter of the optional magnetic powder (C) can be measured by the same method as that for measuring the average particle diameter of the Fe-Ni-Si-Cr-based alloy magnetic powder (A).

A specific surface area of the optional magnetic powder (C) is preferably larger than the specific surface area of the Fe-Ni-Si-Cr-based alloy magnetic powder (A). The specific range of the specific surface area of the optional magnetic powder (C) is preferably 0.1 m²/g or more, more preferably 1.0 m²/g or more, and particularly preferably 2 m²/g or more, and is preferably 40 m²/g or less, more preferably 30 m²/g or less, and particularly preferably 20 m²/g or less.

The particles of the optional magnetic powder (C) are preferably spherical or ellipsoidal particles. A ratio (aspect ratio) obtained by dividing the length of the major axis of the particle of the optional magnetic powder (C) by the length of the minor axis thereof is preferably 2 or less, more preferably 1.5 or less, still more preferably 1.2 or less, and is usually 1.0 or more. In general, when the shape of the particles of the magnetic powder is not spherical but a flat shape, the relative magnetic permeability thereof is easily enhanced. On the other hand, when the shape of the particles of the magnetic powder is close to spherical, the magnetic loss thereof is easily reduced.

A true specific gravity of the optional magnetic powder (C) can be, for example, 4 g/cm³ to 10 g/cm³.

The amount (volume %) of the optional magnetic powder (C) contained in the resin composition may be 0% by volume relative to 100% by volume of the non-volatile components of the resin composition, or may be more than 0% by volume. It is preferably 1% by volume or more, more preferably 5% by volume or more, and particularly preferably 10% by volume or more, and is preferably 40% by volume or less, more preferably 35% by volume or less, and particularly preferably 30% by volume or less. When the amount (volume %) of the optional magnetic powder (C) falls within the above-mentioned range, the relative magnetic permeability and magnetic loss of the cured product of the resin composition can be effectively improved.

The amount (% by mass) of the optional magnetic powder (C) contained in the resin composition may be 0% by mass relative to 100% by mass of the non-volatile components of the resin composition, or may be more than 0% by mass. It is preferably 1% by mass or more, more preferably 5% by mass or more, and particularly preferably 10% by mass or more, and is preferably 40% by mass or less, more preferably 35% by mass or less, and particularly preferably 30% by mass or less. When the amount (% by mass) of the optional magnetic powder (C) falls within the above-mentioned range, the relative magnetic permeability and magnetic loss of the cured product of the resin composition can be effectively improved.

When the Fe-Ni-Si-Cr-based alloy magnetic powder (A) and the optional magnetic powder (C) are used in combination, a volume ratio of the optional magnetic powder (C) to the Fe-Ni-Si-Cr-based alloy magnetic powder (A) (component (C) / component (A)) is preferably within a specified range. Specifically, the volume ratio (component (C) / component (A)) is preferably 0.01 or more, more preferably 0.1 or more, still more preferably 0.2 or more, and particularly preferably 0.3 or more, and is preferably 0.9 or less, more preferably 0.8 or less, and particularly preferably 0.7 or less. When the volume ratio (component (C) / component (A)) falls within the above-mentioned range, the relative magnetic permeability and magnetic loss of the cured product of the resin composition can be effectively improved.

When the Fe-Ni-Si-Cr-based alloy magnetic powder (A) and the optional magnetic powder (C) are used in combination, a mass ratio of the optional magnetic powder (C) to the Fe-Ni-Si-Cr-based alloy magnetic powder (A) (component (C) / component (A)) is preferably within a specified range. Specifically, the mass ratio (component (C) / component (A)) is preferably 0.1 or more, more preferably 0.15 or more, and particularly preferably 0.2 or more, and is preferably 1 or less, more preferably 0.8 or less, and particularly preferably 0.7 or less. When the mass ratio (component (C) / component (A)) falls within the above-mentioned range, the relative magnetic permeability and magnetic loss of the cured product of the resin composition can be effectively improved.

### <(D) Thermoplastic resin>

The resin composition may further contain a thermoplastic resin (D) as an optional component in combination with the components (A) to (C) described above. The thermoplastic resin (D) as the component (D) does not include those corresponding to the components (A) to (C) described above. With the thermoplastic resin (D), the mechanical properties of the cured product of the resin composition can be effectively improved.

Examples of the thermoplastic resin (D) may include a phenoxy resin, a polyimide resin, a polyvinyl acetal resin, a polyolefin resin, a polybutadiene resin, a polyamide-imide resin, a polyetherimide resin, a polysulfone resin, a polyether sulfone resin, a polyphenylene ether resin, a polycarbonate resin, a polyether ether ketone resin, and a polyester resin. As the thermoplastic resin (D), one type thereof may be solely used, and two or more types thereof may also be used in combination.

Examples of the phenoxy resin may include a phenoxy resin having one or more types of skeletons selected from the group consisting of a bisphenol A skeleton, a bisphenol F skeleton, a bisphenol S skeleton, a bisphenol acetophenone skeleton, a novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton. The terminal of the phenoxy resin may be any functional group such as a phenolic hydroxyl group or an epoxy group. Specific examples of the phenoxy resin may include "1256" and "4250" (both of which are bisphenol A skeleton-containing phenoxy resins) manufactured by Mitsubishi Chemical Corporation; "YX8100" (bisphenol S skeleton-containing phenoxy resin) manufactured by Mitsubishi Chemical Corporation; "YX6954" (bisphenol acetophenone skeleton-containing phenoxy resin) manufactured by Mitsubishi Chemical Corporation; "FX280" and "FX293" that are manufactured by Nippon Steel Chemical & Material Co., Ltd.; and "YL7500BH30", "YX6954BH30", "YX7553", "YX7553BH30", "YL7769BH30", "YL6794", "YL7213", "YL7290", "YL7482" and "YL7891BH30" that are manufactured by Mitsubishi Chemical Corporation.

Specific examples of the polyimide resin may include "SLK-6100" manufactured by Shin-Etsu Chemical Co., Ltd., and "Rica Coat SN20" and "Rica Coat PN20" manufactured by New Japan Chemical Co., Ltd. Specific examples of the polyimide resin may include modified polyimides such as linear polyimides (polyimides described in Japanese Patent Application Laid-Open No. 2006-37083 A) and polyimides containing a polysiloxane skeleton (polyimides described in Japanese Patent Application Laid-Open No. 2002-12667 A and Japanese Patent Application Laid-Open No. 2000-319386 A) obtained by reacting a bifunctional hydroxyl group-terminated polybutadiene, a diisocyanate compound, and a tetrabasic acid anhydride.

Examples of the polyvinyl acetal resin may include a polyvinyl formal resin and a polyvinyl butyral resin, with a polyvinyl butyral resin being preferable. Examples of the polyvinyl acetal resin may include "Denka Butyral 4000-2", "Denka Butyral 5000-A", "Denka Butyral 6000-C", and "Denka Butyral 6000-EP" that are manufactured by Denka Company Limited; and Eslek BH series, BX series (e.g., BX-5Z), KS series (e.g., KS-1), BL series, and BM series manufactured by Sekisui Chemical Co., Ltd.

Examples of the polyolefin resin may include ethylene-based copolymer resins such as low-density polyethylene, ultra-low-density polyethylene, high-density polyethylene, an ethylene-vinyl acetate copolymer, an ethylene-ethyl acrylate copolymer, and an ethylene-methyl acrylate copolymer; and polyolefin-based polymers such as polypropylene and an ethylene-propylene block copolymer.

Examples of the polybutadiene resin may include a hydrogenated polybutadiene skeleton-containing resin, a hydroxyl group-containing polybutadiene resin, a phenolic hydroxyl group-containing polybutadiene resin, a carboxy group-containing polybutadiene resin, an acid anhydride group-containing polybutadiene resin, an epoxy group-containing polybutadiene resin, an isocyanate group-containing polybutadiene resin, a urethane group-containing polybutadiene resin, and a polyphenylene ether-polybutadiene resin.

Specific examples of the polyamide-imide resin may include "Viromax HR11NN" and "Viromax HR16NN" manufactured by Toyobo Corporation. Specific examples of the polyamide-imide resin may include modified polyamideimides such as "KS9100" and "KS9300" (polysiloxane skeleton-containing polyamide-imide) manufactured by Hitachi Chemical Co., Ltd.

Specific examples of the polyethersulfone resin may include "PES5003P" manufactured by Sumitomo Chemical Co., Ltd.

Specific examples of the polysulfone resin may include polysulfone "P1700" and "P3500" that are manufactured by Solvay Advanced Polymers Co., Ltd.

Specific examples of the polyphenylene ether resin may include "NORYL SA90" manufactured by SABIC. Specific examples of the polyetherimide resin may include "Ultem" manufactured by GE Co., Ltd.

Examples of the polycarbonate resin may include a hydroxy group-containing carbonate resin, a phenolic hydroxyl group-containing carbonate resin, a carboxy group-containing carbonate resin, an acid anhydride group-containing carbonate resin, an isocyanate group-containing carbonate resin, and a urethane group-containing carbonate resin. Specific examples of the polycarbonate resin may include "FPC0220" manufactured by Mitsubishi Gas Chemical Co., Inc., "T6002" and "T6001" (polycarbonate diol) that are manufactured by Asahi Kasei Chemicals Co., Ltd., and "C-1090", "C-2090", and "C-3090" (polycarbonate diol) that are manufactured by Kuraray Co., Ltd. Specific examples of the polyether ether ketone resin may include "Sumiploy K" manufactured by Sumitomo Chemical Co., Ltd.

Examples of the polyester resin may include a polyethylene terephthalate resin, a polyethylene naphthalate resin, a polybutylene terephthalate resin, a polybutylene naphthalate resin, a polytrimethylene terephthalate resin, a polytrimethylene naphthalate resin, and a polycyclohexane dimethyl terephthalate resin.

The weight-average molecular weight (Mw) of the thermoplastic resin (D) is preferably greater than 5,000, more preferably 8,000 or more, further preferably 10,000 or more, and particularly preferably 20,000 or more. The upper limit is not particularly limited, and may be, for example, 1 million or less, 0.5 million or less, and 0.1 million or less.

The amount (% by mass) of the thermoplastic resin (D) contained in the resin composition may be 0% by mass, or may be more than 0% by mass relative to 100% by mass of the non-volatile components of the resin composition. It is preferably 0.01% by mass or more, more preferably 0.05% by mass or more, and particularly preferably 0.1% by mass or more, and is preferably 5% by mass or less, more preferably 3% by mass or less, and particularly preferably 2% by mass or less,. When the amount of the thermoplastic resin (D) falls within the above-mentioned range, the relative magnetic permeability and magnetic loss of the cured product of the resin composition can be effectively improved.

The amount (% by mass) of the thermoplastic resin (D) contained in the resin composition may be 0% by mass, or may be more than 0% by mass, is preferably 1% by mass or more, more preferably 2% by mass or more, and particularly preferably 3% by mass or more, and is preferably 15% by mass or less, more preferably 10% by mass or less, and particularly preferably 5% by mass or less, relative to 100% by mass of the resin component of the resin composition. When the amount of the thermoplastic resin (D) falls within the above-mentioned range, the relative magnetic permeability and magnetic loss of the cured product of the resin composition can be effectively improved.

### <Dispersant (E)>

The resin composition according to an embodiment of the present invention may further contain a dispersant (E) as an optional component in combination with the above-described components (A) to (D). The dispersant (E) as the component (E) does not include those corresponding to the above-described components (A) to (D). With the dispersant (E), it is possible to enhance the dispersibility of the magnetic powder such as the Fe-Ni-Si-Cr-based alloy magnetic powder (A) and the optional magnetic powder (C).

There is no limitation on the type of dispersant (E). For example, as the dispersant (E), a dispersant that contains a functional group having an adsorption ability with respect to the magnetic powder and that disperses the magnetic powders by repulsion (for example, electrostatic repulsion, steric repulsion, or the like) between the dispersants (E) when the dispersant (E) is adsorbed on the magnetic powder can be used. Examples of the dispersant (E) may include an acidic dispersant and a basic dispersant.

The acidic dispersant usually contains an acidic functional group such as a carboxyl group, a sulfo group (-SO₃H), a sulfonic acid group (-OSO₃H), a phosphono group (-PO(OH)₂), a phosphonooxy group (-OPO(OH)₂), a hydroxyphosphoryl group (-PO(OH)-), and a sulfanyl group (-SH). The acidic functional group usually has a dissociable proton and may be neutralized by a base such as an amine or a hydroxide ion. Examples of preferable acidic dispersants may include an acidic macromolecular dispersant containing a macromolecular chain such as a polyoxyalkylene chain and a polyether chain. Preferable examples of the acidic dispersant may include: "C-2093I" and "SC-1015F (polyfunctional comb-type functional polymer having an ionic group in the main chain and a polyoxyalkylene chain in the graft chain)" that are manufactured by manufactured by NOF Corp.; "ED152", "ED153", "ED154", "ED118", "ED174", "ED251", and "DA-375" (polyether-type phosphoric acid ester-based dispersant) that are manufactured by Kusumoto Chemicals, Ltd.; "RS-410", "RS-610", and "RS-710" (pH is 1.9) (phosphoric acid ester-based dispersant) that are manufactured by Toho Chemical Industry Co., Ltd.; and "AKM-0531", "AFB-1521", "SC-0505K", and "SC-0708A" that are manufactured by NOF Corp. as "Malialim" series.

The basic dispersant usually contains a basic functional group, such as primary, secondary and tertiary amino groups; an ammonium group; an imino group; and a nitrogen-containing heterocyclic group such as pyridine, pyrimidine, pyrazine, imidazole, triazole, and the like. The basic functional group may be neutralized by an acid such as an organic acid or an inorganic acid. Preferable examples of the basic dispersant may include a basic macromolecular dispersant containing a macromolecular chain such as a polyester chain. Preferable examples of the basic dispersant may include "PB-881" (polyamine-based dispersant containing a polyester chain) manufactured by Ajinomoto Fine-Techno Co., Inc.

As the dispersant (E), one type thereof may be solely used, and two or more types thereof may also be used in combination.

The amount (% by mass) of the dispersant (E) contained in the resin composition may be 0% by mass relative to 100% by mass of the non-volatile components of the resin composition, or may be more than 0% by mass. It is preferably 0.01% by mass or more, more preferably 0.1% by mass or more, and particularly preferably 0.2% by mass or more, and is preferably 5% by mass or less, more preferably 3% by mass or less, and particularly preferably 2% by mass or less. When the amount of the dispersant (E) falls within the above-mentioned range, the relative magnetic permeability and magnetic loss of the cured product of the resin composition can be effectively improved.

The amount (% by mass) of the dispersant (E) contained in the resin composition may be 0% by mass relative to 100% by mass of the resin component of the resin composition, or may be more than 0% by mass. It is preferably 1% by mass or more, more preferably 3% by mass or more, and particularly preferably 5% by mass or more, and is preferably 30% by mass or less, more preferably 25% by mass or less, and particularly preferably 20% by mass or less. When the amount of the dispersant (E) falls within the above-mentioned range, the relative magnetic permeability and magnetic loss of the cured product of the resin composition can be effectively improved.

### <Curing accelerator (F)>

The resin composition may further contain a curing accelerator (F) as an optional component in combination with the above-described components (A) to (E). The curing accelerator (F) as a component (F) does not include those corresponding to the above-described components (A) to (E). Since the curing accelerator (F) has a function as a catalyst for the reaction of the thermosetting resin (B), it can accelerate the curing of the resin composition.

Examples of the curing accelerator (F) may include a phosphorus-based curing accelerator, an imidazole-based curing accelerator, an amine-based curing accelerator, a guanidine-based curing accelerator, a metal-based curing accelerator, and a urea-based curing accelerator. As the curing accelerator (F), one type thereof may be solely used, and two or more types thereof may also be used in combination. Among these, as the curing accelerator (F), a phosphorus-based curing accelerator and an imidazole-based curing accelerator are preferable, and a phosphorus-based curing accelerator is more preferable.

Examples of the phosphorus-based curing accelerator may include phosphonium salts and phosphines. Examples of the phosphonium salts may include aliphatic phosphonium salts such as tetrabutylphosphonium bromide, tetrabutylphosphonium chloride, tetrabutylphosphonium acetate, tetrabutylphosphonium decanoate, tetrabutylphosphonium laurate, n-butylphosphonium tetraphenylborate, bis(tetrabutylphosphonium)pyromellitate, tetrabutylphosphonium hydrogenhexahydrophthalate, tetrabutylphosphonium 2,6-bis[(2-hydroxy-5-methylphenyl)methyl]-4-methylphenolate, and di-tert-butylmethylphosphonium tetraphenylborate; and aromatic phosphonium salts such as methyltriphenylphosphonium bromide, ethyltriphenylphosphonium bromide, propyltriphenylphosphonium bromide, butyltriphenylphosphonium bromide, benzyltriphenylphosphonium chloride, tetraphenylphosphonium bromide, p-tolyltriphenylphosphonium tetra-p-tolylborate, tetraphenylphosphonium tetraphenylborate, tetraphenylphosphonium tetra-p-tolylborate, triphenylethylphosphonium tetraphenylborate, tris(3-methylphenyl)ethylphosphonium tetraphenylborate, tris(2-methoxyphenyl)ethylphosphonium tetraphenylborate, (4-methylphenyl)triphenylphosphonium thiocyanate, tetraphenylphosphonium thiocyanate, and butyltriphenylphosphonium thiocyanate.

Examples of phosphines may include aliphatic phosphines such as tributylphosphine, tri-tert-butylphosphine, trioctylphosphine, di-tert-butyl(2-butenyl)phosphine, di-tert-butyl(3-methyl-2-butenyl)phosphine, and tricyclohexylphosphine; aromatic phosphines such as dibutylphenylphosphine, di-tert-butylphenylphosphine, methyldiphenylphosphine, ethyldiphenylphosphine, butyldiphenylphosphine, diphenylcyclohexylphosphine, triphenylphosphine, tri-o-tolylphosphine, tri-m-tolylphosphine, tri-p-tolylphosphine, tris(4-ethylphenyl)phosphine, tris(4-propylphenyl)phosphine, tris(4-isopropylphenyl)phosphine, tris(4-butylphenyl)phosphine, tris(4-tert-butylphenyl)phosphine, tris(2,4-dimethylphenyl)phosphine, tris(2,5-dimethylphenyl)phosphine, tris(2,6-dimethylphenyl)phosphine, tris(3,5-dimethylphenyl)phosphine, tris(2,4,6-trimethylphenyl)phosphine, tris(2,6-dimethyl-4-ethoxyphenyl)phosphine, tris(2-methoxyphenyl)phosphine, tris(4-methoxyphenyl)phosphine, tris(4-ethoxyphenyl)phosphine, tris(4-tert-butoxyphenyl)phosphine, diphenyl-2-pyridylphosphine, 1,2-bis(diphenylphosphino)ethane, 1,3-bis(diphenylphosphino)propane, 1,4-bis(diphenylphosphino)butane, 1,2-bis(diphenylphosphino)acetylene, and 2,2'-bis(diphenylphosphino)diphenylether; aromatic phosphine-borane complexes such as triphenylphosphine-triphenylborane; and aromatic phosphine-quinone addition products such as triphenylphosphine-p-benzoquinone addition product.

As the phosphorus-based curing accelerator, a commercially available product may be used, and examples thereof may include "TBP-DA" manufactured by Hokko Chemical Industry Co., Ltd.

Examples of the imidazole-based curing accelerator may include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanuric acid adduct, 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, and 2-phenylimidazoline, and adducts of imidazole compounds and epoxy resins. Of these, 2-ethyl-4-methylimidazole and 1-benzyl-2-phenylimidazole are preferable. As the imidazole-based curing accelerator, a commercially available product may be used, and examples thereof may include "P200-H50" manufactured by Mitsubishi Chemical Corporation; and "CUREZOL 2MZ", "2E4MZ", "Cl1Z", "Cl1Z-CN", "Cl1Z-CNS", "Cl1Z-A", "2MZ-OK", "2MA-OK", "2MA-OK-PW", "2MZA-PW", "2PHZ", "2PHZ-PW", "1B2PZ", and "1B2PZ-10M" that are manufactured by Shikoku Chemicals Corporation.

Examples of the amine-based curing accelerator may include trialkylamine such as triethylamine and tributylamine, 4-dimethylaminopyridine, benzyldimethylamine, 2,4,6-tris(dimethylaminomethyl)phenol, 1,8-diazabicyclo(5,4,0)-undecene, 1,8-diazabicyclo[5,4,0]undecene-7,4-dimethylaminopyridine, and 2,4,6-tris(dimethylaminomethyl)phenol. Among these, 4-dimethylaminopyridine is preferable. As the amine-based curing accelerator, a commercially available product may be used, and examples thereof may include "PN-50", "PN-23", and "MY-25" that are manufactured by Ajinomoto Fine-Techno Co., Inc.

Examples of the guanidine-based curing accelerator may include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]dec-5-ene, 7-methyl-1,5,7-triazabicyclo[4.4.0]dec-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide. Among these, dicyandiamide and 1,5,7-triazabicyclo[4.4.0]dec-5-ene are preferable.

Examples of the metal-based curing accelerator may include organometallic complexes or organometallic salts of metals such as cobalt, copper, zinc, iron, nickel, manganese, and tin. Specific examples of the organometallic complex may include an organocobalt complex such as cobalt (II) acetylacetonate and cobalt (III) acetylacetonate, an organocopper complex such as copper (II) acetylacetonate, an organozinc complex such as zinc (II) acetylacetonate, an organoiron complex such as iron (III) acetylacetonate, an organonickel complex such as nickel (II) acetylacetonate, and an organomanganese complex such as manganese (II) acetylacetonate. Examples of the organometallic salt may include zinc octylate, tin octylate, zinc naphthenate, cobalt naphthenate, tin stearate, and zinc stearate.

Examples of the urea-based curing accelerator may include 1,1-dimethylurea; aliphatic dimethylureas such as 1,1,3-trimethylurea, 3-ethyl-1,1-dimethylurea, 3-cyclohexyl-1,1-dimethylurea, and 3-cyclooctyl-1,1-dimethylurea; and aromatic dimethylurea such as 3-phenyl-1,1-dimethylurea, 3-(4-chlorophenyl)-1,1-dimethylurea, 3-(3,4-dichlorophenyl)-1,1-dimethylurea, 3-(3-chloro-4-methylphenyl)-1,1-dimethylurea, 3-(2-methylphenyl)-1,1-dimethylurea, 3-(4-methylphenyl)-1,1-dimethylurea, 3-(3,4-dimethylphenyl)-1,1-dimethylurea, 3-(4-isopropylphenyl)-1,1-dimethylurea, 3-(4-methoxyphenyl)-1,1-dimethylurea, 3-(4-nitrophenyl)-1,1-dimethylurea, 3-[4-(4-methoxyphenoxy)phenyl]-1,1-dimethylurea, 3-[4-(4-chlorophenoxy)phenyl]-1,1-dimethylurea, 3-[3-(trifluoromethyl)phenyl]-1,1-dimethylurea, N,N-(1,4-phenylene)bis(N',N'-dimethylurea), and N,N-(4-methyl-1,3-phenylene)bis(N',N'-dimethylurea) [toluene bisdimethylurea].

The amount (% by mass) of the curing accelerator (F) contained in the resin composition may be 0% by mass relative to 100% by mass of the non-volatile components of the resin composition, or may be more than 0% by mass. It is preferably 0.001% by mass or more, more preferably 0.005% by mass or more, and particularly preferably 0.01% by mass or more, and is preferably 3% by mass or less, more preferably 2% by mass or less, and particularly preferably 1% by mass or less.

The amount (% by mass) of the curing accelerator (F) contained in the resin composition may be 0% by mass relative to 100% by mass of the resin component of the resin composition, or may be more than 0% by mass. It is preferably 0.1% by mass or more, more preferably 0.3% by mass or more, and particularly preferably 0.5% by mass or more, and is preferably 5% by mass or less, more preferably 3% by mass or less, and particularly preferably 2% by mass or less.

The total content of the component (B), component (E) and component (F) is preferably 1% by mass or more, more preferably 1.5% by mass or more, and still more preferably 2% by mass or more, and is preferably 10% by mass or less, more preferably 8% by mass or less, and still more preferably 5% by mass or less, relative to 100% by mass of the non-volatile components of the resin composition.

### <Optional additive (G)>

The resin composition according to an embodiment of the present invention may further include an optional additive (G) as an optional component in combination with the above-described components (A) to (F). The optional additive (G) as the component (G) does not include those corresponding to the components (A) to (F) described above.

Examples of the optional additive (G) may include a radical polymerizable compound such as a maleimide-based radical polymerizable compound, a vinylphenyl-based radical polymerizable compound, a (meth)acryl-based radical polymerizable compound, an allyl-based radical polymerizable compound, and a polybutadiene-based radical polymerizable compound; a radical polymerization initiator such as a peroxide-based radical polymerization initiator and an azo-based radical polymerization initiator; an inorganic filler such as silica particles; an organic filler such as rubber particles; an organometallic compound such as an organocopper compound and an organozinc compound; a polymerization inhibitor such as hydroquinone, catechol, pyrogallol, and phenothiazine; a leveling agent such as a silicone-based leveling agent and an acrylic polymer-based leveling agent; a thickener such as bentone and montmorillonite; a defoamer such as a silicone-based defoamer, an acryl-based defoamer, a fluorine-based defoamer, and a vinyl resin-based defoamers; a UV absorber such as a benzotriazole-based UV absorber; an adhesion improver such as urea silane; an adhesion imparting agent such as a triazole-based adhesion imparting agent, a tetrazole-based adhesion imparting agent, and a triazine-based adhesion imparting agent; an antioxidant such as a hindered phenol-based antioxidant; a flame retardant such as a phosphorus-based flame retardant (e.g., a phosphate ester compound, a phosphazene compound, a phosphinic acid compound, and red phosphorus), a nitrogen-based flame retardant (e.g., melamine sulfate), a halogen-based flame retardant, and an inorganic flame retardant (e.g., antimony trioxide); and a stabilizer such as a borate-based stabilizer, a titanate-based stabilizer, an aluminate-based stabilizer, a zirconate-based stabilizer, an isocyanate-based stabilizer, a carboxylic acid-based stabilizer, and a carboxylic anhydride-based stabilizer. As the optional additive (G), one type thereof may be solely used, and two or more types thereof may also be used in combination.

### <Solvent (H)>

The resin composition may further contain a solvent (H) as a volatile component in combination with non-volatile components such as the components (A) to (G) described above.

As the solvent (H), an organic solvent is usually used. Examples of the solvent (H) may include a ketone-based solvent such as acetone, methyl ethyl ketone, methyl isobutyl ketone, and cyclohexanone; an ester-based solvent such as methyl acetate, ethyl acetate, butyl acetate, isobutyl acetate, isoamyl acetate, methyl propionate, ethyl propionate, and γ-butyrolactone; an ether-based solvent such as tetrahydropyran, tetrahydrofuran, 1,4-dioxane, diethyl ether, diisopropyl ether, dibutyl ether, and diphenyl ether; an alcohol-based solvent such as methanol, ethanol, propanol, butanol, and ethylene glycol; an ether-ester-based solvent such as 2-ethoxyethyl acetate, propylene glycol monomethyl ether acetate, diethylene glycol monoethyl ether acetate, ethyl diglycol acetate, γ-butyrolactone, and methyl methoxypropionate; an ester alcohol-based solvent such as methyl lactate, ethyl lactate, and methyl 2-hydroxyisobutyrate; an ether alcohol-based solvent such as 2-methoxypropanol, 2-methoxyethanol, 2-ethoxyethanol, propylene glycol monomethyl ether, and diethylene glycol monobutyl ether (butyl carbitol); an amide-based solvent such as N,N-dimethylformamide, N,N-dimethylacetamide, and N-methyl-2-pyrrolidone; a sulfoxide-based solvent such as dimethyl sulfoxide; a nitrile-based solvent such as acetonitrile and propionitrile; an aliphatic hydrocarbon-based solvent such as hexane, cyclopentane, cyclohexane, and methylcyclohexane; and an aromatic hydrocarbon-based solvent such as benzene, toluene, xylene, ethylbenzene, and trimethylbenzene. As the solvent (H), one type thereof may be solely used, and two or more types thereof may also be used in combination.

The amount of the solvent (H) is preferably set so that the melt viscosity of the resin composition can be adjusted to an appropriate range. The amount of the solvent (H) relative to 100% by mass of the non-volatile component in the resin composition may be, for example, 3% by mass or less, 1% by mass or less, 0.5% by mass or less, 0.1% by mass or less, or 0.01% by mass or less. Among these, it is particularly preferable that the resin composition do not contain the solvent (H). When the amount of the solvent (H) is small, generation of voids due to volatilization of the solvent (H) can be suppressed. In addition, the handling property and workability of the resin composition can be improved.

### <Properties of resin composition>

The resin composition described above can be cured by heat. Therefore, a cured product of the resin composition can be obtained by thermally curing the resin composition. Usually, among the components included in the resin composition, volatile components such as the solvent (H) and the like can be volatilized by heat at the time of thermal curing, but non-volatile components such as the components (A) to (G) are not volatilized by heat at the time of thermal curing. Thus, the cured product of the resin composition may include non-volatile components of the resin composition or reaction products thereof.

According to the resin composition of the present embodiment, a cured product having a low melt viscosity, a high relative magnetic permeability, and a low magnetic loss can be obtained. Usually, the cured product of the resin composition according to the present embodiment has a lower melt viscosity than that of a cured product of a conventional resin composition containing an Si- and Cr-free Fe-Ni-based alloy magnetic powder and that of a conventional resin composition containing a Cr-free Fe-Ni-Si-based alloy magnetic powder.

Therefore, according to the resin composition, a cured product having a high relative magnetic permeability can be obtained. For example, when the relative magnetic permeability of a cured product obtained by thermally curing the resin composition at 190°C for 90 minutes is measured at a measuring frequency of 20 MHz and a room temperature of 23°C, the relative magnetic permeability is preferably 23 or more, more preferably 23.5 or more, and particularly preferably 24 or more. The upper limit of the relative magnetic permeability is not particularly limited, and may be, for example, 35 or less, or 30 or less. The relative magnetic permeability of the cured product can be measured by the method described in Examples to be described later.

According to the resin composition, a cured product having a low magnetic loss can be obtained. The magnetic loss can be represented by a magnetic loss tangent tanδ and usually the smaller the magnetic loss tangent tanδ is, the smaller the magnetic loss is. For example, when the magnetic loss tangent tanδ of a cured product obtained by thermally curing the resin composition at 190°C for 90 minutes is measured at a measured frequency of 20 MHz and a room temperature of 23°C, the magnetic loss tangent tanδ is preferably 0.04 or less, more preferably 0.038 or less, and particularly preferably 0.035 or less. The lower limit of the magnetic loss tangent is not particularly limited, and may be, for example, 0.00001 or more. The magnetic loss tangent tanδ of the cured product can be measured by the method described in the following Examples.

The resin composition has a property of a low melt viscosity. Therefore, it is possible to facilitate the filling of the resin composition into a hole without dissolving it with a solvent or the like. The melt viscosity is preferably 30,000 poise or less, more preferably 25,000 poise or less, and even more preferably 23,000 poise or less. The lower limit is not particularly limited, and may be, for example, 100 poise or more. The melt viscosity can be measured by the method described in the following Examples.

In general, crystalline alloy powders, such as alloy powders containing Fe and Ni, can have a high relative magnetic permeability while tending to have a high magnetic loss. In addition, its melt viscosity tends to increase. Therefore, conventionally, it is difficult to obtain a resin composition having a low melt viscosity and a cured product having a high relative magnetic permeability and a small magnetic loss. In view of such conventional circumstances, the effects of the present invention are industrially advantageous.

There is no particular limitation on the forms of the resin composition. Thus, the resin composition may be in the form of a solid or a paste having fluidity. For example, the resin composition may be prepared as a paste-like resin composition using a solvent, or as a paste-like resin composition containing no solvent by using a liquid thermosetting resin such as a liquid epoxy resin. In the case where the content of the solvent in the resin composition is small and where the solvent is not contained, generation of voids due to volatilization of a solvent can be suppressed, and the handling property and the workability can further be improved.

It is preferable to use the resin composition as a resin composition for producing an inductor by utilizing the above-described excellent characteristics. For example, the resin composition described above is preferably used as a hole-filling resin composition for filling holes in a substrate included in a circuit substrate. Further, for example, the resin composition described above is preferably used for forming a cured product layer on a circuit substrate. In order to facilitate application to these use applications, the resin composition may be used in the form of a paste or in the form of a resin sheet containing a layer of the resin composition.

### <Method for producing resin composition>

The resin composition according to an embodiment of the present invention can be produced, for example, by mixing the above-described components. Part or all of the components described above may be mixed simultaneously or may be mixed sequentially. In the course of mixing the respective components, the temperature may be set as appropriate, and thus the respective components may be heated and/or cooled temporarily or throughout. Stirring or shaking may be performed in the process of mixing the respective components. Furthermore, defoaming may be performed under low pressure conditions such as under vacuum.

### <Magnetic paste>

A magnetic paste according to an embodiment of the present invention includes the resin composition described above. Since the magnetic paste is usually a fluid paste containing the resin composition, it can be preferably used for filling holes by a printing method. The magnetic paste may contain only the resin composition described above, or may contain an optional component in combination with the resin composition. Preferably, the paste-like resin composition itself can be used as a magnetic paste.

The magnetic paste is preferably in a paste form at 23°C. The viscosity of the magnetic paste at 23°C is preferably 20 Pa·s or more, more preferably 25 Pa·s or more, still more preferably 30 Pa·s or more, and particularly preferably 50 Pa·s or more, and is preferably 200 Pa·s or less, more preferably 180 Pa·s or less, and still more preferably 160 Pa·s or less. The viscosity can be measured using, for example, an E-type viscometer ("RE-80U" manufactured by Toki Sangyo Co., Ltd., 3° × R9.7 rotor) with a measurement sample volume of 0.22 ml and a measurement speed of 5 rpm.

### <Resin sheet>

A resin sheet according to an embodiment of the present invention includes a support and a resin composition layer provided on the support. The resin composition layer includes the resin composition described above, and preferably includes only the resin composition.

The thickness of the resin composition layer is preferably 250 µm or less, more preferably 200 µm or less, from the viewpoint of thinning. The lower limit of the thickness of the resin composition layer may be, for example, 5 µm or more, and 10 µm or more.

Examples of the support may include a film made of a plastic material, a metal foil, and a release paper. A film made of a plastic material and a metal foil are preferable.

When a film of a plastic material is used as the support, examples of the plastic material may include a polyester such as polyethylene terephthalate (hereinafter sometimes abbreviated as "PET") and polyethylene naphthalate (hereinafter sometimes abbreviated as "PEN"), polycarbonate (hereinafter sometimes abbreviated as "PC"), an acrylic polymer such as polymethyl methacrylate (PMMA), a cyclic polyolefin, triacetyl cellulose (TAC), polyether sulfide (PES), polyether ketone, and polyimide. Among these, polyethylene terephthalate and polyethylene naphthalate are preferable, and inexpensive polyethylene terephthalate is particularly preferable.

When a metal foil is used as the support, examples of the metal foil may include a copper foil and an aluminum foil. A copper foil is preferable. As the copper foil, a foil made of a single metal of copper may be used, and a foil made of an alloy of copper and another metal (for example, tin, chromium, silver, magnesium, nickel, zirconium, silicon, titanium, or the like) may be used.

The support may be subjected to a mat treatment or a corona treatment on a surface to be bonded to the resin composition layer.

As the support, a support with a release layer on a surface to be bonded to the resin composition layer may be used. As the release agent used for the release layer of the support with a release layer, for example, one or more types of release agents selected from the group consisting of an alkyd-based release agent, a polyolefin-based release agent, a urethane-based release agent, and a silicone-based release agent may be mentioned. As the support with a release layer, a commercially available product may be used, and examples thereof include "PET501010", "SK-1", "AL-5", and "AL-7" that are manufactured by LINTEC Corporation; "Lumillor T60" manufactured by Toray Industries Inc.; "Purex" manufactured by Teijin Ltd.; and "Unipeel" manufactured by Unitika Ltd. They are PET films having a release layer containing a silicone-based release agent or an alkyd resin-based release agent as a main component.

The thickness of the support is not particularly limited, but is preferably in a range of 5 µm to 75 µm, and more preferably in a range of 10 µm to 60 µm. When a support with a release layer is used, the thickness of the entire support with a release layer preferably falls within the above-mentioned range.

In the resin sheet, a protective film corresponding to the support may be provided on a surface of the resin composition layer that is not bonded to the support (that is, a surface opposite to the support). The thickness of the protective film is not particularly limited, but is, for example, 1 µm to 40 µm. By providing the protective film, adhesion of dust or the like to the surface of the resin composition layer and scratches formed thereon can be suppressed.

The resin sheet can be produced, for example, by coating the resin composition on a support using a die coater or the like to form a resin composition layer. As necessary, an organic solvent may be mixed with the resin composition and then the mixture may be applied onto the support. When an organic solvent is used, drying may be performed after coating, as necessary.

The drying may be performed by, for example, heating, hot air blowing, or the like. The drying condition is not particularly limited, but the layer is dried such that the content of the organic solvent in the resin composition layer becomes 10% by mass or less, preferably 5% by mass or less. The resin composition layer can be formed by drying the layer at 50°C to 150°C for 3 minutes to 10 minutes depending on the components contained in the resin composition.

The resin sheet can be wound and stored in a roll form. When the resin sheet has a protective film, the resin sheet is usually ready for use after peeling off the protective film.

### <Circuit substrate and production method thereof>

The circuit substrate includes the cured product of the resin composition described above. The specific structure of the circuit substrate is not particularly limited as long as the cured product of the resin composition is included. A circuit substrate according to a first example includes a substrate having holes and a cured product of a resin composition with which the holes are filled. A circuit substrate according to a second example includes a cured product layer containing a cured product of a resin composition. Hereinafter, methods for producing the circuit substrates according to the first and second examples will be described. However, a circuit substrate and a method for producing the circuit substrate are not limited to the first and second examples illustrated below as examples.

### <Circuit substrate according to first example>

The circuit substrate according to the first example includes a substrate having holes formed therein and a cured product of a resin composition with which the holes are filled. This circuit substrate can be produced by a production method including, for example,
(1) a step of filling holes of a substrate with a resin composition, and
(2) a step of thermally curing the resin composition to obtain a cured product.
   The method for producing the circuit substrate according to the first example may further include
(3) a step of polishing a surface of the cured product or the resin composition,
(4) a step of performing a roughening treatment to the cured product, and
(5) a step of forming a conductor layer on the cured product. Usually, the step (1), step (2), step (3), step (4), and step (5) may be performed in this order, or the step (2) may be performed after the step (3). In the method for producing the circuit substrate according to the first example, it is preferable to form a cured product using a paste-like resin composition. In the following description, an example in which a substrate has through holes formed therein as holes penetrating the substrate in the thickness direction will be described.

### <Step (1)>

The step (1) usually includes a step of preparing a substrate having through holes formed therein. A commercially available substrate may be used as the substrate. Alternatively, a substrate produced using an appropriate material may be used as the substrate. Hereinafter, a method for producing a substrate according to an example will be described.

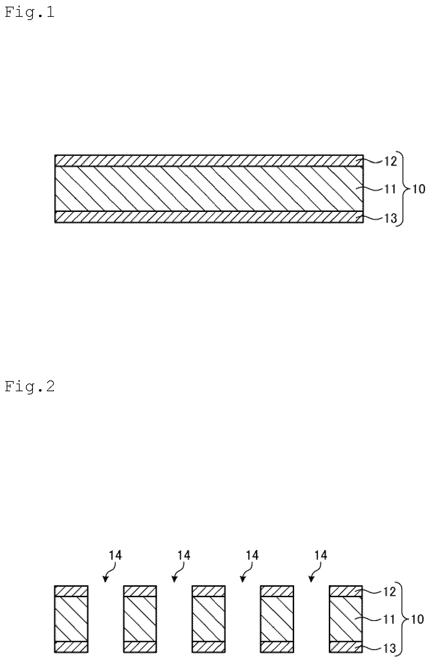

Fig. 1 is a cross-sectional view schematically illustrating a core substrate 10 prepared in a method for producing a circuit substrate according to the first example of the embodiment of the present invention. The step of preparing a substrate may include, as in the example shown in Fig. 1, a step of preparing the core substrate 10. The core substrate 10 usually contains a support substrate 11. Examples of the support substrate 11 may include insulation substrates such as a glass epoxy substrate, a metal substrate, a polyester substrate, a polyimide substrate, a BT resin substrate, and a thermosetting polyphenylene ether substrate. A metal layer may be disposed on the support substrate 11. The metal layer may be disposed on either one surface or both surfaces of the support substrate 11. Here, an example in which metal layers 12 and 13 are disposed on both surfaces of the support substrate 11 is shown. An example of the metal layers 12 and 13 is a layer formed of a metal such as copper. The metal layers 12 and 13 may be, for example, a copper foil such as a carrier-attached copper foil or a metal layer formed of a material of a conductor layer described later.

Fig. 2 is a cross-sectional view schematically illustrating the core substrate 10 having through holes 14 formed therein in the method for producing a circuit substrate according to the first example of the embodiment of the present invention. Like the example shown in Fig. 2, the step of preparing a substrate may include a step of forming through holes 14 in the core substrate 10. The through holes 14 can be formed by, for example, a method such as drilling, laser irradiation, or plasma irradiation. Usually, the through holes 14 can be formed by forming through holes to the core substrate 10. As a specific example, the through holes 14 can be formed using a commercially available drilling device. An example of a commercially available drilling device is "ND-1S211" manufactured by Hitachi Via Mechanics, Ltd.

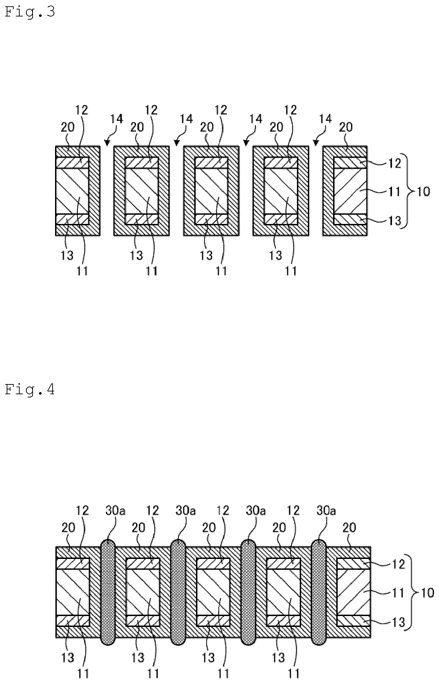

Fig. 3 is a cross-sectional view schematically illustrating the core substrate 10 in which plated layers 20 are formed inside the through holes 14 in the method for producing a circuit substrate according to the first example of the embodiment of the present invention. The step of preparing a substrate may include a step of performing a roughening treatment to the core substrate 10, as necessary, and thereafter forming plated layers 20 as shown in Fig. 3. The roughening treatment may be a dry or wet roughening treatment. An example of the dry roughening treatment is a plasma treatment. An example of the wet roughening treatment is a method of performing a swelling treatment with a swelling liquid, a roughening treatment with an oxidant, and a neutralizing treatment with a neutralizing liquid in this order. The plated layers 20 can be formed by a plating method. The procedure for forming the plated layers 20 by a plating method can be the same as that for forming a conductor layer in the step (5) described later. Here, an example in which the plated layers 20 are formed inside the through holes 14, on the surfaces of the metal layers 12, and on the surfaces of the metal layers 13 will be described.

Fig. 4 is a cross-sectional view schematically illustrating that the through holes of the core substrate 10 are filled with the resin composition 30a in the method for producing a circuit substrate according to the first example of the embodiment of the present invention. The step (1) includes filling the through holes 14 of the core substrate 10 with a resin composition 30a as shown in Fig. 4, after preparing the core substrate 10 having the through holes 14 formed therein as described above. The filling can be performed by, for example, a printing method. Examples of the printing method may include a method of printing the resin composition 30a onto the through holes 14 via a squeegee, a method of printing the resin composition 30a via a cartridge, a method of printing the resin composition 30a by mask printing, a roll coating method, and an inkjet method.

### <Step (2)>

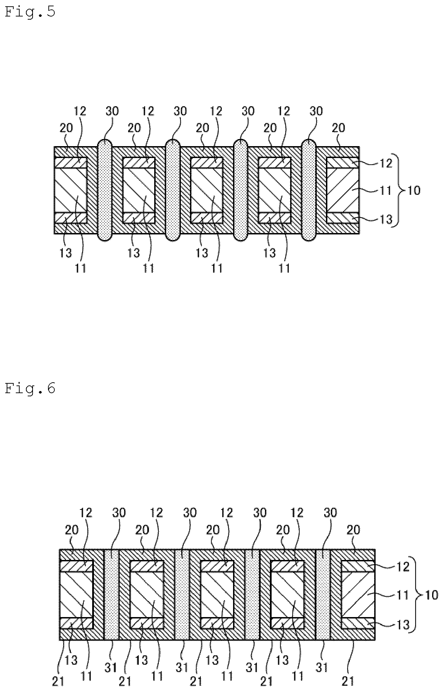

Fig. 5 is a schematic cross-sectional view for explaining the step (2) of the method for producing a circuit substrate according to the first example of the embodiment of the present invention. The step (2) includes, after filling the through holes 14 with the resin composition 30a, curing the resin composition 30a to form a cured product 30 as shown in Fig. 5.

The curing of the resin composition 30a is usually performed by thermal curing. The thermal curing conditions of the resin composition 30a can be adequately set within a range in which the curing of the resin composition 30a proceeds. The curing temperature is preferably 120°C or higher, more preferably 130°C or higher, and further preferably 150°C or higher, and is preferably 245°C or lower, more preferably 220°C or lower, and further preferably 200°C or lower. The curing time is preferably 5 minutes or more, more preferably 10 minutes or more, and further preferably 15 minutes or more, and is preferably 120 minutes or less, more preferably 110 minutes or less, and further preferably 100 minutes or less.

The curing degree of the cured product 30 obtained in the step (2) is preferably 80% or more, more preferably 85% or more, and further preferably 90% or more. The curing degree can be measured by, for example, using a differential scanning calorimeter.

The method for producing the circuit substrate according to the first example may include, after filling the through holes 14 with the resin composition 30a and before curing the resin composition 30a, a step (preheating step) of heating the resin composition 30a at a temperature lower than the curing temperature. For example, prior to curing the resin composition 30a, the resin composition 30a may be preheated at usually 50°C or higher and lower than 120°C (preferably 60°C or higher and 110°C or lower, more preferably 70°C or higher and 100°C or lower) for usually 5 minutes or more (preferably 5 minutes to 150 minutes, more preferably 15 minutes to 120 minutes).

### <Step (3)>

Fig. 6 is a schematic cross-sectional view for explaining the step (3) of the method for producing a circuit substrate according to the first example of the embodiment of the present invention. When filling the through holes 14 with the resin composition 30a in step (1), the excess resin composition 30a may externally protrude from or attach to the through holes 14. Therefore, the resin composition 30a is provided not only inside the through holes 14 but also outside the through holes 14. Therefore, the step (3) includes, as shown in Fig. 6, polishing the excess cured product 30 projecting from or attached to the core substrate 10. Since the polishing removes the excess cured product 30, the surface of the cured product 30 can be flattened. Furthermore, a surface (polished surface) 31 of the cured product 30 flattened by polishing can usually form a planar surface that is flush with a surface 21 around the polished surface 31 (for example, the surface of the core substrate 10 and the surfaces of the plated layers 20).

As the polishing method of the cured product 30, a method by which the excess cured product 30 projecting from or attached to the core substrate 10 can be removed can be adopted. Examples of such a polishing method may include buff polishing, belt polishing, and ceramic polishing. An example of a commercially available buff polisher is "NT-700IM" manufactured by Ishii Hyoki Co., Ltd.

From the viewpoint of improving adhesion with a conductor layer, the arithmetic average roughness (Ra) of the polished surface 31 (surface after curing) of the cured product 30 is preferably 300 nm or more, more preferably 350 nm or more, and further preferably 400 nm or more. The upper limit is preferably 1000 nm or less, more preferably 900 nm or less, and further preferably 800 nm or less. The surface roughness (Ra) can be measured by, for example, using a non-contact type surface roughness tester.

The method for producing the circuit substrate according to the first example may include, after the step (3), a step of performing a thermal treatment to the cured product 30 to further increase the curing degree of the cured product 30. The temperature in the thermal treatment can be in accordance with the above-mentioned curing temperature. Specifically, the thermal treatment temperature is preferably 120°C or higher, more preferably 130°C or higher, and further preferably 150°C or higher, and is preferably 245°C or lower, more preferably 220°C or lower, and further preferably 200°C or lower. The thermal treatment time is preferably 5 minutes or more, more preferably 10 minutes or more, and further preferably 15 minutes or more, and is preferably 90 minutes or less, more preferably 70 minutes or less, and further preferably 60 minutes or less.

When the step (3) is performed before the step (2), a preheating treatment of heating at a temperature lower than the curing temperature of the resin composition may be performed before the step (3). The temperature in the preheating treatment is preferably 100°C or higher, more preferably 110°C or higher, and further preferably 120°C or higher, and is preferably 245°C or lower, more preferably 220°C or lower, and further preferably 200°C or lower. The thermal treatment time is preferably 5 minutes or more, more preferably 10 minutes or more, and further preferably 15 minutes or more, and is preferably 90 minutes or less, more preferably 70 minutes or less, and further preferably 60 minutes or less.

### <Step (4)>

The step (4) includes performing a roughening treatment (desmear treatment) to the cured product 30. The surface of the cured product 30 is roughened by a roughening treatment. When the surface of the cured product 30 is polished, performing a roughening treatment (desmear treatment) to the polished surface 31 thereof is usually included. The procedure and conditions of the roughening treatment are not particularly limited, and can be, for example, the procedure and conditions used in the method for producing a multilayer printed wiring board. As a specific example, a swelling treatment with a swelling liquid, a roughening treatment with an oxidant, and a neutralizing treatment with a neutralizing liquid can be performed in this order to perform the roughening treatment to the cured product 30.

Examples of the swelling liquid used in the roughening step may include an alkali solution and a surfactant solution and an alkali solution is preferable. The alkali solution as the swelling liquid is more preferably a sodium hydroxide solution or a potassium hydroxide solution. Examples of a commercially available swelling liquid may include a "Swelling Dip Securiganth P" and a "Swelling Dip Securiganth SBU" that are manufactured by Atotech Japan.

The swelling treatment with the swelling liquid can be performed by, for example, immersing the cured product 30 in the swelling liquid at 30°C to 90°C for 1 minute to 20 minutes. From the viewpoint of suppressing swelling of the resin contained in the cured product 30 to an appropriate level, it is preferable to immerse the cured product 30 in the swelling liquid at 40°C to 80°C for 5 minutes to 15 minutes.

An example of the oxidant usable in the roughening treatment with an oxidant may be an alkaline permanganic acid solution in which potassium permanganate or sodium permanganese is dissolved in an aqueous solution of sodium hydroxide. The roughening treatment with an oxidant such as an alkaline permanganic acid solution is preferably performed by immersing the cured product 30 in an oxidant solution heated to 60°C to 80°C for 10 minutes to 30 minutes. The concentration of the permanganic acid salt in the alkaline permanganic acid solution is preferably 5% by mass to 10% by mass. Examples of a commercially available oxidant may include an alkaline permanganic acid solution such as a "Concentrate Compact P" and a "Dosing Solution Securiganth P" that are manufactured by Atotech Japan.

The neutralizing liquid usable in the neutralizing treatment is preferably an acidic aqueous solution. An example of a commercially available neutralizing liquid is a "Reduction Solution Securiganth P" manufactured by Atotech Japan. The neutralizing treatment with the neutralizing liquid can be performed by immersing the treatment surface, which has been subjected to the roughening treatment using the oxidant solution, in a neutralizing liquid at 30°C to 80°C for 5 minutes to 30 minutes. In terms of workability or the like, the method of immersing the cured product 30, which has been subjected to the roughening treatment using the oxidant solution, in a neutralizing liquid at 40°C to 70°C for 5 minutes to 20 minutes is preferable.

From the viewpoint of improving adhesion with a conductor layer, the arithmetic average roughness (Ra) of the surface of the cured product 30 is preferably 300 nm or more, more preferably 350 nm or more, and further preferably 400 nm or more. The upper limit is preferably 1500 nm or less, more preferably 1200 nm or less, and further preferably 1000 nm or less. The surface roughness (Ra) can be measured by, for example, using a non-contact type surface roughness tester.

### <Step (5)>

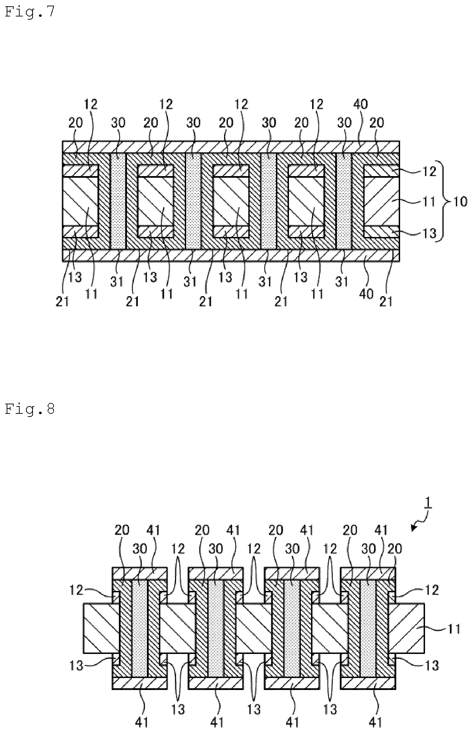

Fig. 7 is a schematic cross-sectional view for explaining the step (5) of the method for producing a circuit substrate according to the first example of the embodiment of the present invention. As shown in Fig. 7, the step (5) includes forming a conductor layer 40 on the polished surface 31 of the cured product 30. Here, an example in which the conductor layer 40 was formed not only on the polished surface 31 of the cured product 30 but also on the surface 21 therearound (for example, the surface of the core substrate 10 and the surfaces of the plated layers 20) is shown. Although Fig. 7 illustrates an example in which the conductor layer 40 is formed on both sides of the core substrate 10, the conductor layer 40 may be formed on only one side of the core substrate 10.

Fig. 8 is a schematic cross-sectional view for explaining the step (5) of the method for producing a circuit substrate according to the first example of the embodiment of the present invention. As shown in Fig. 8, the step (5) may include, after forming the conductor layer 40, removing part of the conductor layer 40, the metal layers 12, the metal layers 13, and the plated layers 20 by a treatment such as etching to form patterned conductor layers 41.

The method for forming the conductor layer 40 may be, for example, a plating method, a sputtering method, and a vapor deposition method, and is particularly preferably a plating method. In a suitable embodiment, the surface of the cured product 30 (and the plated layers 20) can be plated by an appropriate method such as a semi-additive method or a full-additive method to form the patterned conductor layers 41 having desired wiring patterns. Examples of the material of the conductor layer 40 may include a single metal such as gold, platinum, palladium, silver, copper, aluminum, cobalt, chromium, zinc, nickel, titanium, tungsten, iron, tin, and indium; and an alloy of two or more metals selected from the group of gold, platinum, palladium, silver, copper, aluminum, cobalt, chromium, zinc, nickel, titanium, tungsten, iron, tin, and indium. Among these, the material is preferably chromium, nickel, titanium, aluminum, zinc, gold, palladium, silver, or copper, or a nickel chromium alloy, a copper nickel alloy, or a copper titanium alloy, more preferably chromium, nickel, titanium, aluminum, zinc, gold, palladium, silver, or copper, or a nickel chromium alloy, and further preferably copper, from the viewpoint of versatility, cost, patterning easiness, and the like.

Here, an example of the method of forming the patterned conductor layers 41 on the polished surface 31 of the cured product 30 will be described in detail. A plating seed layer is formed on the polished surface 31 of the cured product 30 by electroless plating. Subsequently, an electrolytic plated layer is formed on the formed plating seed layer by electrolytic plating. After that, an unnecessary plating seed layer can be removed by a treatment such as etching as necessary to form patterned conductor layers 41 having desired wiring patterns. After forming the patterned conductor layers 41, an annealing treatment may be performed as necessary in order to enhance adhesion strength of the patterned conductor layers 41. The annealing treatment can be performed by, for example, heating at 150 to 200°C for 20 to 90 minutes.

From the viewpoint of making the layers thinner, the thickness of the patterned conductor layers 41 is preferably 70 µm or less, more preferably 60 µm or less, further preferably 50 µm or less, further more preferably 40 µm or less, and particularly preferably 30 µm or less, 20 µm or less, 15 µm or less, or 10 µm or less. The lower limit is preferably 1 µm or more, more preferably 3 µm or more, and further preferably 5 µm or more.

A circuit substrate 1 containing the cured product 30 of the resin composition 30a can be produced by the above-mentioned method.

### <Circuit substrate according to second example>

The circuit substrate according to the second example includes a cured product layer containing a cured product of a resin composition. The cured product layer preferably contains only a cured product of a resin composition. The cured product layer is preferably formed using a resin sheet. This circuit substrate can be produced by a production method including, for example,
(i) a step of forming a cured product layer on an inner layer substrate,
(ii) a step of performing a drilling process onto the cured product layer,
(iii) a step of performing a roughening treatment onto the surface of the cured product layer, and
(iv) a step of forming a conductor layer on the surface of the cured product layer.

### <Step (i)>

The step (i) includes forming a cured product layer on an inner layer substrate. Preferably, the step (i) includes laminating a resin sheet onto an inner layer substrate such that a resin composition layer is connected to the inner layer substrate to form a cured product layer. For example, the resin sheet is laminated to the inner layer substrate such that the resin composition layer is connected to the inner layer substrate, and the resin composition layer is thermally cured to form the cured product layer.

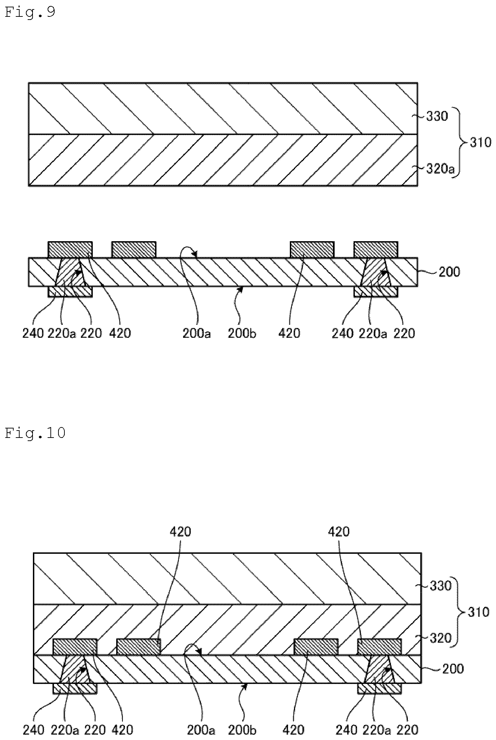

Fig. 9 is a schematic cross-sectional view for explaining the step (i) in the method for producing a circuit substrate according to the second example of the embodiment of the present invention. As shown in Fig. 9, a resin sheet 310 containing a support 330 and a resin composition layer 320a disposed on the support 330 is prepared. Then, the resin sheet 310 and an inner layer substrate 200 are laminated together such that the resin composition layer 320a is connected to the inner layer substrate 200.

As the inner layer substrate 200, an insulation substrate can be used. Examples of the inner layer substrate 200 may include insulation substrates such as a glass epoxy substrate, a metal substrate, a polyester substrate, a polyimide substrate, a BT resin substrate, and a thermosetting polyphenylene ether substrate. The inner layer substrate 200 may be an inner layer circuit substrate in which a wiring and the like are built in the thickness direction.

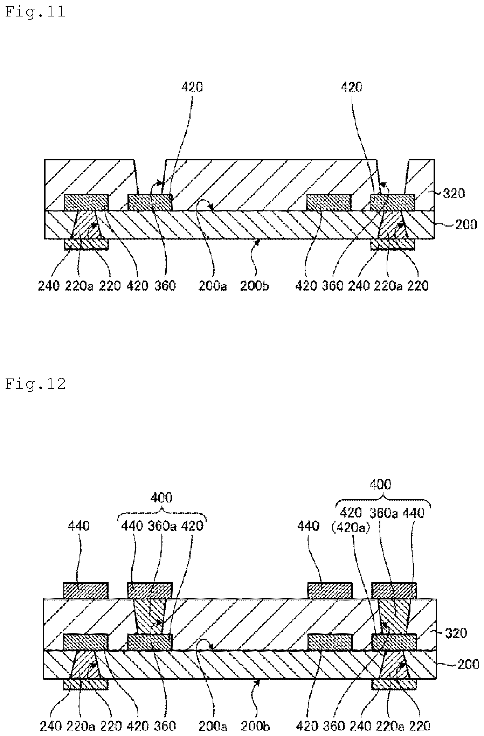

The inner layer substrate 200 illustrated in the present example includes a first conductor layer 420 disposed on a first main surface 200a and an external terminal 240 disposed on a second main surface 200b. The first conductor layer 420 may contain a plurality of wirings. However, in the example shown in Fig. 9, only a wiring constituting a coiled conductive structure body 400 (see Fig. 12) of an inductor element is shown. The external terminal 240 can be a terminal for electrically connecting to an unshown external device or the like. The external terminal 240 can be constituted as a part of a conductor layer disposed to the second main surface 200b.

Examples of the conductor material constituting the first conductor layer 420 and the external terminal 240 may be the same as those of the material of the conductor layer described in the first example.

The first conductor layer 420 and the external terminal 240 may have either a single-layer structure or a multilayer structure containing two or more layers in which single-metal layers or alloy layers made of different types of metals or alloys are laminated together. The thicknesses of the first conductor layer 420 and the external terminal 240 can be the same as that of a second conductor layer 440 described later.

The line/space (L/S) of the first conductor layer 420 and the external terminal 240 is not particularly limited, and is usually 900/900 µm or less, preferably 700/700 µm or less, more preferably 500/500 µm or less, further preferably 300/300 µm or less, and further more preferably 200/200 µm or less, from the viewpoint of reducing unevenness between the surfaces and obtaining a cured product layer having excellent smoothness. The lower limit of the line/space is not particularly limited, and is preferably 1/1 µm or more, from the viewpoint of improving the embedding of the resin composition layer into the space.

The inner layer substrate 200 may have a plurality of through holes 220 that penetrate the inner layer substrate 200 from the first main surface 200a to the second main surface 200b. To each of the through holes 220, an in-through-hole wiring 220a is disposed. The in-through-hole wiring 220a electrically connects the first conductor layer 420 and the external terminal 240.

The connection between the resin composition layer 320a and the inner layer substrate 200 is performed by, for example, hot-press-bonding the resin sheet 310 to the inner layer substrate 200 from the support 330 side. Examples of a member (hereinafter, also referred to as a "hot-press-bonding member") for hot-press-bonding the resin sheet 310 to the inner layer substrate 200 may include a heated metal plate (stainless (SUS) end plate or the like) and a metal roll (SUS roll). Note that it is not preferable for the hot-press-bonding member and the resin sheet 310 to be pressed by being brought into direct contact with each other. Instead, they are preferably pressed via a sheet or the like made of an elastic material such as heat-resistant rubber such that the shape of the resin sheet 310 sufficiently follows the unevenness of the surface of the inner layer substrate 200.

The temperature in the hot-press bonding is in a range of preferably 80°C to 160°C, more preferably 90°C to 140°C, and further preferably 100°C to 120°C. The pressure in the hot-press bonding is in a range of preferably 0.098 MPa to 1.77 MPa and more preferably 0.29 MPa to 1.47 MPa. The time in the hot-press bonding is in a range of preferably 20 seconds to 400 seconds and more preferably 30 seconds to 300 seconds. The connection between the resin sheet and the inner layer substrate is preferably performed under the reduced pressure condition at a pressure of 26.7 hPa or less.

The connection between the resin composition layer 320a of the resin sheet 310 and the inner layer substrate 200 can be performed by a commercially available vacuum laminator. Examples of the commercially available vacuum laminator may include a vacuum pressure laminator manufactured by Meiki Co., Ltd. and a vacuum applicator manufactured by Nikko-Materials Co., Ltd.

After connecting the resin sheet 310 and the inner layer substrate 200, the laminated resin sheet 310 may be subjected to a smoothing treatment under normal pressure (under atmospheric pressure), for example, by pressing the hot-press-bonding member from the support 330 side. The pressing conditions used for the smoothing treatment can be similar to those of the hot-press-bonding of the above-mentioned lamination. The smoothing treatment can be performed by a commercially available laminator. Note that the lamination and the smoothing treatment may be consecutively performed using the above-mentioned commercially available vacuum laminator.

Fig. 10 is a schematic cross-sectional view for explaining the step (i) in the method for producing a circuit substrate according to the second example of the embodiment of the present invention. After laminating the resin sheet 310 to the inner layer substrate 200, the resin composition layer 320a is cured to form a cured product layer. In the present example, as shown in Fig. 10, the resin composition layer 320a connected to the inner layer substrate 200 is thermally cured to form a first cured product layer 320.

The thermal curing condition of the resin composition layer 320a can be adequately set within a range in which the curing of the resin composition proceeds. The curing temperature is preferably 120°C or higher, more preferably 130°C or higher, and further preferably 150°C or higher, and is preferably 245°C or lower, more preferably 220°C or lower, and further preferably 200°C or lower. The curing time is preferably 5 minutes or more, more preferably 10 minutes or more, and further preferably 15 minutes or more, and is preferably 120 minutes or less, more preferably 110 minutes or less, and further preferably 100 minutes or less.

The support 330 may be removed either after the thermal curing in the step (i) but before the step (ii) or after the step (ii).

From the viewpoint of improving adhesion with plating, the arithmetic average roughness (Ra) of the cured product layer before the roughening treatment is preferably 300 nm or more, more preferably 350 nm or more, and further preferably 400 nm or more. The upper limit is preferably 1,000 nm or less, more preferably 900 nm or less, and further preferably 800 nm or less. The arithmetic average roughness (Ra) can be measured by, for example, using a non-contact type surface roughness tester.

In the step (i), the resin composition, instead of the resin sheet, may be applied onto the inner layer substrate 200 using a die coater or the like and thermally cured to form a cured product layer.

### <Step (ii)>

Fig. 11 is a schematic cross-sectional view for explaining the step (ii) in the method for producing a circuit substrate according to the second example of the embodiment of the present invention. The step (ii) includes, as shown in Fig. 11, drilling the first cured product layer 320 to form via holes 360. The via holes 360 each form a path for electrically connecting the first conductor layer 420 to the second conductor layer 440 described later. The via hole 360 may be formed by, for example, using a drill, lasers, or plasma. The size and shape of the hole may be appropriately determined depending on the design of the printed wiring board.

### <Step (iii)>

In the step (iii), the surface of the cured product layer where the via holes have been formed is subjected to a roughening treatment. The roughening treatment in the step (iii) can be performed by the same method as that described in the step (4) of the first example.

From the viewpoint of improving adhesion with plating, the arithmetic average roughness (Ra) of the cured product layer after the roughening treatment is preferably 300 nm or more, more preferably 350 nm or more, and further preferably 400 nm or more. The upper limit is preferably 1,500 nm or less, more preferably 1,200 nm or less, and further preferably 1,000 nm or less. The surface roughness (Ra) can be measured by, for example, using a non-contact type surface roughness tester.

### <Step (iv)>

Fig. 12 is a schematic cross-sectional view for explaining the step (iv) in the method for producing a circuit substrate according to the second example of the embodiment of the present invention. As shown in Fig. 12, the step (iv) includes forming the second conductor layer 440 on the first cured product layer 320.

Examples of the conductor material constituting the second conductor layer 440 may be the same as those of the material of the conductor layer described in the first example.

From the viewpoint of thinning, the thickness of the second conductor layer 440 is preferably 70 µm or less, more preferably 60 µm or less, further preferably 50 µm or less, further more preferably 40 µm or less, and particularly preferably 30 µm or less, 20 µm or less, 15 µm or less, or 10 µm or less. The lower limit is preferably 1 µm or more, more preferably 3 µm or more, and further preferably 5 µm or more.

The second conductor layer 440 can be formed by plating. The second conductor layer 440 is preferably formed by, for example, a wet plating method such as a semi-additive method or a full-additive method containing an electroless plating process, a mask pattern forming process, an electrolytic plating process, and a flash etching process. When the second conductor layer 440 is formed by a wet plating method, the second conductor layer 440 containing a desired wiring pattern can be formed. Note that in-via-hole wirings 360a are also formed in the via holes 360 by this step.

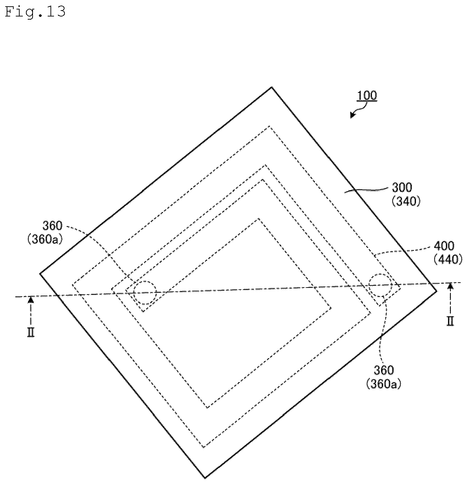

The first conductor layer 420 and the second conductor layer 440 may be disposed in a spiral shape, for example, as shown in the examples of Figs. 13 to 15. In an example, one end at the center side of the spiral-shaped wiring part of the second conductor layer 440 is electrically connected to one end at the center side of the spiral-shaped wiring part of the first conductor layer 420 via the in-via-hole wiring 360a. The other end at the outer circumferential side of the spiral-shaped wiring part of the second conductor layer 440 is electrically connected to a land 420a of the first conductor layer 420 via the in-via-hole wiring 360a. Therefore, the other end at the outer circumferential side of the spiral-shaped wiring part of the second conductor layer 440 is electrically connected to the external terminal 240 via the in-via-hole wiring 360a, the land 420a, and the in-through-hole wiring 220a.

A coiled conductive structure body 400 includes a spiral-shaped wiring part as a portion of the first conductor layer 420, a spiral-shaped wiring part as a portion of the second conductor layer 440, and the in-via-hole wiring 360a that electrically connects the spiral-shaped wiring part of the first conductor layer 420 and the spiral-shaped wiring part of the second conductor layer 440.

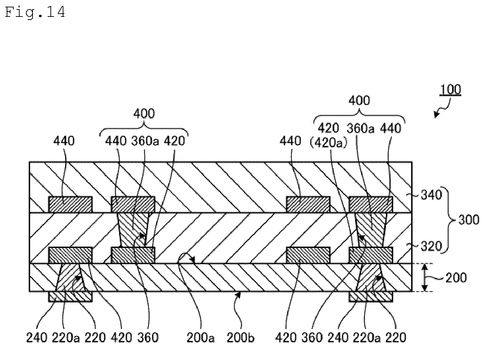

After the step (iv), a step of forming an additional cured product layer on the conductor layer may be performed. In particular, as shown in the example of Fig. 14, a second cured product layer 340 is formed on the second conductor layer 440 and the first cured product layer 320 in which the in-via-hole wiring 360a is formed. The second cured product layer may be formed by a step similar to the above-mentioned step. According to the above-mentioned method, a circuit substrate 100 including the first cured product layer 320 and the second cured product layer 340 both formed of the cured product of the resin composition can be produced.

### <Inductor substrate>

The inductor substrate includes the above-mentioned circuit substrate. When such an inductor substrate includes the circuit substrate obtained by the above-mentioned method for producing a circuit substrate according to the first example, it can have an inductor pattern formed by the conductor in at least a portion of the surroundings of the cured product of the resin composition. In this case, the inductor substrate can include an inductor element that contains, for example, an inductor pattern formed of at least a portion of the metal layer 12, the metal layer 13, the plated layer 20, and the patterned conductor layer 41, and a core formed of the cured product 30 surrounded by this inductor pattern. As such an inductor substrate, one disclosed in Japanese Patent Application Laid-Open No. 2016-197624 A, for example, can be adopted.

When the inductor substrate includes the circuit substrate obtained by the method for producing the circuit substrate according to the second example, it can have a cured product layer and a conductive structure body that is partly embedded in this cured product layer. This inductor substrate can include an inductor element constituted by the conductive structure body and a portion of the cured product layer that extends in the thickness direction of the cured product layer and that is surrounded by the conductive structure body.

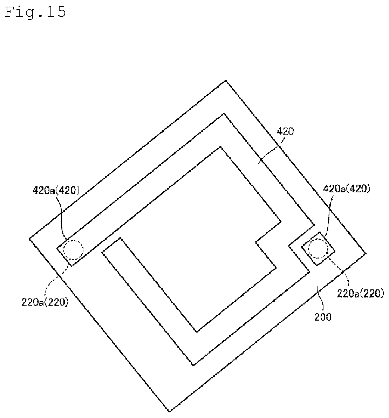

Fig. 13 is a schematic plan view when the circuit substrate 100 of the inductor substrate is seen from one side of the thickness direction. Fig. 14 is a schematic view illustrating a cut end surface of the circuit substrate 100 cut along a dash-dotted line II-II shown in Fig. 13. Fig. 15 is a schematic plan view for explaining a configuration of the first conductor layer 420 of the circuit substrate 100 of the inductor substrate.

As shown in Fig. 13 and Fig. 14 as an example, the circuit substrate 100 can be a substrate including a plurality of cured product layers (the first cured product layer 320 and the second cured product layer 340) and a plurality of conductor layers (the first conductor layer 420 and the second conductor layer 440). Therefore, in the example illustrated herein, the circuit substrate 100 can be a build-up wiring plate having a build-up cured product layer and a build-up conductor layer. Furthermore, the circuit substrate 100 includes the inner layer substrate 200.

As shown in Fig. 14, the first cured product layer 320 and the second cured product layer 340 constitute a magnetic unit 300 that can be regarded as an integral cured product layer. Therefore, the coiled conductive structure body 400 is disposed to be at least partly embedded in the magnetic unit 300. That is, in the circuit substrate 100 shown in this example, the inductor element is constituted by the coiled conductive structure body 400, and a core that is a portion of the magnetic unit 300 that extends in the thickness direction of the magnetic unit 300 and that is surrounded by the coiled conductive structure body 400.

As shown in Fig. 15 as an example, the first conductor layer 420 includes a spiral-shaped wiring part for constituting the coiled conductive structure body 400 and the rectangular land 420a electrically connected to the in-through-hole wirings 220a. In the example illustrated herein, the spiral-shaped wiring part contains a linear portion, a bent portion that bends at a right angle, and a bypass that bypasses the land 420a. The entirety of the spiral-shaped wiring part of the first conductor layer 420 has a substantially rectangular contour and has a shape of being wound counterclockwise from the center side toward the outer side.

Similarly, the second conductor layer 440 is disposed on the first cured product layer 320. The second conductor layer 440 contains a spiral-shaped wiring part for constituting the coiled conductive structure body 400. In Fig. 13 or Fig. 14, the spiral-shaped wiring part contains a linear portion and a bent portion that bends at a right angle. In Fig. 13 or Fig. 14, the entirety of the spiral-shaped wiring part of the second conductor layer 440 has a substantially rectangular contour and has a shape of being wound clockwise from the center side toward the outer side.

The inductor substrate can be used as a wiring board for mounting an electronic part such as a semiconductor chip and also can be used as a (multilayer) printed wiring board in which such a wiring board is used as an inner layer substrate. Furthermore, the inductor substrate can be used as a chip inductor part obtained by separating such a wiring board into pieces and also can be used as a printed wiring board in which the chip inductor part is surface mounted.

Furthermore, such a wiring board can be used to produce semiconductor devices of various aspects. The semiconductor devices including such a wiring board can be suitably used for electric products (for example, a computer, a cell phone, a digital camera, and a TV set) and vehicles (for example, a motorcycle, an automobile, an electric train, a vessel, and an aircraft).

### EXAMPLES

Hereinafter, examples of the present invention will be more specifically described. The present invention is not limited to these examples. Note that in the following description, "%" and "parts" indicating an amount denote "% by mass" and "parts by mass" unless otherwise specified. Further, the temperature condition when the temperature is not particularly specified is room temperature (23°C). Furthermore, the pressure condition when the pressure is not particularly specified is normal pressure (1 atm).

### <Example 1: Production of varnish-like resin composition 1>

A varnish-like resin composition 1 was prepared by uniformly dispersing, in 6.7 parts by mass of a solvent (methyl ethyl ketone), 150.0 parts by mass of an Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀) : 5 µm, true density: 8.0 g/cm³), 30.0 parts by mass of a magnetic powder ("MZ03S" manufactured by Powdertech Co., Ltd., Mn-Zn-based ferrite powder, average particle diameter (D₅₀): 0.5 µm, true density: 5.1 g/cm³), 3.7 parts by mass of an epoxy resin ("ZX-1059" manufactured by Nippon Steel Chemical & Material Co., Ltd., mixed product of a bisphenol A type epoxy resin and a bisphenol F type epoxy resin, epoxy equivalent: 169 g/eq., true density: 1.2 g/cm³), 4.2 parts by mass of a phenol resin ("LA-7054"manufactured by DIC Corporation, amino triazine modified phenol Novolac resin, MEK solution containing 60% of non-volatile component, hydroxyl group equivalent: 125 g/eq., true density of non-volatile component: 1.2 g/cm³), 1.1 parts by mass of phenoxy resin ("YX7553BH30" manufactured by Mitsubishi Chemical Corporation, solution of methyl ethyl ketone:cyclohexanone = 1:1 containing 30% of non-volatile component, special backbone phenoxy resin, true density of non-volatile component: 1.2 g/cm³), 0.8 part by mass of a dispersant ("PB-881" manufactured by Ajinomoto Fine-Techno Co., Inc., polyester-based dispersant, true density: 1.2 g/cm³), and 0.1 part by mass of a curing accelerator ("2E4MZ" manufactured by Shikoku Chemicals Corporation, imidazole-based curing accelerator, true density: 1.2 g/cm³).

### <Example 2: Preparation of varnish-like resin composition 2>

In Example 1,
1) the amount of the Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀): 5 µm, true density: 8.0 g/cm³) was changed from 150.0 parts by mass to 133.6 parts by mass, and
2) the amount of the magnetic powder ("MZ03S" manufactured by Powdertech Co., Ltd., Mn-Zn-based ferrite powder, average particle diameter (D₅₀): 0.5 µm, true density: 5.1 g/cm³) was changed from 30.0 parts by mass to 40.0 parts by mass.

A varnish-like resin composition 2 was prepared by the same manner as that in Example 1 except for the above-mentioned matters.

### <Example 3: Preparation of varnish-like resin composition 3>

In Example 1,
1) the amount of the Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀): 5 µm, true density: 8.0 g/cm³) was changed from 150.0 parts by mass to 116.1 parts by mass, and
2) the amount of the magnetic powder ("MZ03S" manufactured by Powdertech Co., Ltd., Mn-Zn-based ferrite powder, average particle diameter (D₅₀): 0.5 µm, true density: 5.1 g/cm³) was changed from 30.0 parts by mass to 51.4 parts by mass.

A varnish-like resin composition 3 was prepared by the same manner as that in Example 1 except for the above-mentioned matters.

### <Example 4 : Preparation of varnish-like resin composition 4>

In Example 1,
1) the amount of the Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀): 5 µm, true density: 8.0 g/cm³) was changed from 150.0 parts by mass to 98.3 parts by mass, and
2) the amount of the magnetic powder ("MZ03S" manufactured by Powdertech Co., Ltd., Mn-Zn-based ferrite powder, average particle diameter (D₅₀): 0.5 µm, true density: 5.1 g/cm³) was changed from 30.0 parts by mass to 61.7 parts by mass.

A varnish-like resin composition 4 was prepared by the same manner as that in Example 1 except for the above-mentioned matters.

### <Example 5 : Preparation of varnish-like resin composition 5>

In Example 2, 40.0 parts by mass of the magnetic powder ("MZ03S" manufactured by Powdertech Co., Ltd., Mn-Zn-based ferrite powder, average particle diameter (D₅₀): 0.5 µm, true density: 5.1 g/cm³) was changed to 40.0 parts by mass of a magnetic powder ("M03S" manufactured by Powdertech Co., Ltd., Mn-based ferrite powder, average particle diameter (D₅₀) : 0.5 µm, true density: 5.0 g/cm³) .

A varnish-like resin composition 5 was prepared by the same manner as that in Example 2 except for the above-mentioned matters.

### <Example 6 : Preparation of varnish-like resin composition 6>

In Example 2, 133.6 parts by mass of the Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀): 5 µm, true density: 8.0 g/cm³) was changed to 133.6 parts by mass of an Fe-Ni-Si-Cr-based alloy magnetic powder ("AKT-PB-3Si-4Cr" manufactured by Mitsubishi Steel Mfg. Co., Ltd., alloy of Fe: 47%, Ni: 46%, Si: 3%, and Cr: 4%, average particle diameter (D₅₀): 5 µm, true density: 8.0 g/cm³) .

A varnish-like resin composition 6 was prepared by the same manner as that in Example 2 except for the above-mentioned matters.

### <Example 7 : Preparation of varnish-like resin composition 7>

In Example 2, 133.6 parts by mass of the Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀): 5 µm, true density: 8.0 g/cm³) was changed to 133.6 parts by mass of an Fe-Ni-Si-Cr-based alloy magnetic powder ("AKT-PB-0.2Si-3Cr" manufactured by Mitsubishi Steel Mfg. Co., Ltd., alloy of Fe: 50.8%, Ni: 46%, Si: 0.2%, and Cr: 3%, average particle diameter (D₅₀): 5 µm, true density: 8.0 g/cm³).

A varnish-like resin composition 7 was prepared by the same manner as that in Example 2 except for the above-mentioned matters.

### <Example 8 : Preparation of varnish-like resin composition 8>

In Example 2, 133.6 parts by mass of the Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀): 5 µm, true density: 8.0 g/cm³) was changed to 133.6 parts by mass of an Fe-Ni-Si-Cr-based alloy magnetic powder ("AKT-PB-1Si-1Cr" manufactured by Mitsubishi Steel Mfg. Co., Ltd., alloy of Fe: 52%, Ni: 46%, Si: 1.0%, and Cr: 1.0%, average particle diameter (D₅₀): 5 µm, true density: 8.0 g/cm³).

A varnish-like resin composition 8 was prepared by the same manner as that in Example 2 except for the above-mentioned matters.

### <Example 9 : Preparation of varnish-like resin composition 9>

In Example 2, 133.6 parts by mass of the Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀): 5 µm, true density: 8.0 g/cm³) was changed to 133.6 parts by mass of an Fe-Ni-Si-Cr-based alloy magnetic powder ("AKT-PB-1Si-6Cr" manufactured by Mitsubishi Steel Mfg. Co., Ltd., alloy of Fe: 47%, Ni: 46%, Si: 1.0%, and Cr: 6.0%, average particle diameter (D₅₀): 5 µm, true density: 8.0 g/cm³).

A varnish-like resin composition 9 was prepared by the same manner as that in Example 2 except for the above-mentioned matters.

### <Comparative Example 1 : Preparation of varnish-like resin composition 10>

In Example 2, 133.6 parts by mass of the Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀): 5 µm, true density: 8.0 g/cm³) was changed to 133.6 parts by mass of an Fe-Ni-Si-Cr-based alloy magnetic powder ("AKT-PB-1Si-8Cr" manufactured by Mitsubishi Steel Mfg. Co., Ltd., alloy of Fe: 45%, Ni: 46%, Si: 1.0%, and Cr: 8.0%, average particle diameter (D₅₀): 5 µm, true density: 8.0 g/cm³).

A varnish-like resin composition 10 was prepared by the same manner as that in Example 2 except for the above-mentioned matters.

### <Comparative Example 2 : Preparation of varnish-like resin composition 11>

In Example 2, 133.6 parts by mass of the Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀): 5 µm, true density: 8.0 g/cm³) was changed to 133.6 parts by mass of an Fe-Ni-Si-based alloy magnetic powder ("50FE50%NI PF-5F" manufactured by Epson Atmix Corporation., alloy of Fe: 49%, Ni: 50%, and Si: 0.4%, average particle diameter (D₅₀): 5 µm, true density: 8.0 g/cm³) .

A varnish-like resin composition 11 was prepared by the same manner as that in Example 2 except for the above-mentioned matters.

### <Comparative Example 3 : Preparation of varnish-like resin composition 13>

In Example 2, 133.6 parts by mass of the Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀): 5 µm, true density: 8.0 g/cm³) was changed to 133.6 parts by mass of an Fe-Ni-Mo-based alloy magnetic powder ("AKT-78N1-5Mo" manufactured by Mitsubishi Steel Mfg. Co., Ltd., alloy of Fe: 17%, Ni: 78%, and Mo: 5%, average particle diameter (D₅₀) : 5 µm, true density: 8.9 g/cm³).

A varnish-like resin composition 12 was prepared by the same manner as that in Example 2 except for the above-mentioned matters.

### <Comparative Example 4 : Preparation of varnish-like resin composition 14>

In Example 2,
1) 133.6 parts by mass of the Fe-Ni-Si-Cr-based alloy magnetic powder ("AKT-PB-1Si-3Cr" manufactured by Mitsubishi Steel Mfg. Co., Ltd., alloy of Fe: 50%, Ni: 46%, Si: 1%, and Cr: 3%, average particle diameter (D₅₀) : 5 µm, true density: 8.0 g/cm³) was changed to 100.0 parts by mass of an Fe-Si-Cr-based alloy magnetic powder ("AW2-08PF3F" manufactured by Epson Atmix Corporation., Fe-Si-Cr alloy, average particle diameter (D₅₀): 3.5 µm, true density: 7.0 g/cm³), and
2) the amount of the magnetic powder ("MZ03S" manufactured by Powdertech Co., Ltd., Mn-Zn-based ferrite powder, average particle diameter (D₅₀): 0.5 µm, true density: 5.1 g/cm³) was changed from 40.0 parts by mass to 51.4 parts by mass.

A varnish-like resin composition 13 was prepared by the same manner as that in Example 2 except for the above-mentioned matters.

### <Production of resin sheet>

A PET film ("Lumirror R80" manufactured by Toray Industries, Inc., thickness: 38 µm, softening point: 130°C) subjected to a mold-releasing treatment with an alkyd resin-based mold-releasing agent ("AL-5" manufactured by Lintec Corporation) was prepared as the support. The varnish-like resin compositions (resin varnish) prepared in Examples and Comparative Examples were each applied onto the support using a die coater such that the resin composition layer after drying had a thickness of 70 µm, and dried at 90°C for 5 minutes to obtain a resin sheet.

### <Production of sheet-like cured body>

The resin sheet was cut to a 200 mm square. The cut resin sheet (200 mm square) was laminated to one surface of a polyimide film ("Upilex 25S" manufactured by Ube Industries, Ltd., thickness: 25 µm, 240 mm square) using a batch-type vacuum pressure laminator (two-stage build-up laminator "CVP700" manufactured by Nikko-Materials Co., Ltd), such that the resin composition layer was in contact with the center of the smooth surface of the polyimide film. The lamination was performed by reducing a pressure for 30 seconds to a pressure of 13 hPa or lower and thereafter contact-bonding at 100°C and a pressure of 0.74 MPa for 30 seconds. Accordingly, there was obtained a multilayer film having a layer configuration of support / resin composition layer / polyimide film.

After peeling the support, the resin composition layer was heated at 190°C for 90 minutes thereby to be thermally cured. After that, the polyimide film was peeled to obtain a sheet-like cured body of the resin composition.

<Measurement of relative magnetic permeability and magnetic loss tangent>

The obtained sheet-like cured body was cut to obtain a doughnut-like evaluation sample having an outer diameter of 19.2 mm and an inner diameter of 8.2 mm. The relative magnetic permeability (µ') and magnetic loss tangent (tanδ) of this evaluation sample were measured at a measurement frequency of 20 MHz and the room temperature of 23°C using a Magnetic Material Test Fixture "16454A" manufactured by Keysight Co. and an Impedance Analyzer "E4991B" manufactured by Keysight Co. The magnetic loss tangent tanδ was calculated according to the following equation "tanδ = µ"/µ'".

The evaluation criteria of the relative magnetic permeability are as follows.
"○": The relative magnetic permeability is 23 or more.
"×": The relative magnetic permeability is less than 23.

The evaluation criteria of the magnetic loss tangent are as follows.
"○": The magnetic loss tangent is 0.05 or less.
"×": The magnetic loss tangent exceeds 0.05.

### <Evaluation of melt viscosity>

After peeling the support of the resin sheet, the resin composition layer was compressed by a metal mold to prepare measurement pellets (diameter 18 mm, 3.5 g to 3.7 g). After that, the minimum melt viscosity of the measurement pellets was measured using a dynamic viscoelasticity measuring device ("Rheosol-G3000" manufactured by UBM Co.). Specifically, 1 g of the measurement pellets was increased in temperature within a temperature range from an onset temperature of 60°C to 200°C using a parallel plate with a diameter of 18 mm to measure the dynamic viscoelasticity rate and calculate the minimum melt viscosity (poise). The measurement condition was a temperature increasing rate of 5°C/min, a measurement temperature interval of 2.5°C, a frequency of 1 Hz, and a distortion of 1 deg. The evaluation criteria of the melt viscosity are as follows.
"O": The melt viscosity is 30,000 poise or less.
"×": The melt viscosity exceeds 30,000 poise.

**[Table 1]**

| (Table 1) | | | | | | | | | | | | | | | |
|---|---|---|---|---|---|---|---|---|---|---|---|---|---|---|---|
| | | | Example | | | | | | | | | Comparative Example | | | |
| | | | 1 | 2 | 3 | 4 | 5 | 6 | 7 | 8 | 9 | 1 | 2 | 3 | 4 |
| Component (A) | | AKT-PB-1Si-3Cr | 150.0 | 133.6 | 116.1 | 98.3 | 133.6 | | | | | | | | |
| | | AKT-PB-3Si-4Cr | | | | | | 133.6 | | | | | | | |
| | | AKT-PB-0.2Si-3Cr | | | | | | | 133.6 | | | | | | |
| | | AKT-PB-1Si-1Cr | | | | | | | | 133.6 | | | | | |
| | | AKT-PB-1Si-6Cr | | | | | | | | | 133.6 | | | | |
| Component (B) | Component (B-1) | ZX-1059 | 3.7 | 3.7 | 3.7 | 3.7 | 3.7 | 3.7 | 3.7 | 3.7 | 3.7 | 3.7 | 3.7 | 3.7 | 3.7 |
| | Component (B-2) | LA-7054 | 4.2 | 4.2 | 4.2 | 4.2 | 4.2 | 4.2 | 4.2 | 4.2 | 4.2 | 4.2 | 4.2 | 4.2 | 4.2 |
| Component (C) | | MOSS | | | | | 40.0 | | | | | | | | |
| | | MZ03S | 30.0 | 40.0 | | 61.7 | | 40.0 | 40.0 | 40.0 | 40.0 | 40.0 | 40.0 | 40.0 | 51.4 |
| | | AKT-PB-1Si-8Cr | | | | | | | | | | 133.6 | | | |
| | | 50FE50%NI PF-5F | | | | | | | | | | | 133.6 | | |
| | | AKT-78Ni-5Mo | | | | | | | | | | | | 133.6 | |
| | | AW2-08PF3F | | | | | | | | | | | | | 100.0 |
| Component (D) | | YX7553BH30 | 1.1 | 1.1 | 1.1 | 1.1 | 1.1 | 1.1 | 1.1 | 1.1 | 1.1 | 1.1 | 1.1 | 1.1 | 1.1 |
| Component (E) | | PB-881 | 0.8 | 0.8 | 0.8 | 0.8 | 0.8 | 0.8 | 0.8 | 0.8 | 0.8 | 0.8 | 0.8 | 0.8 | 0.8 |
| Component (F) | | 2E4MZ | 0.1 | 0.1 | 0.1 | 0.1 | 0.1 | 0.1 | 0.1 | 0.1 | 0.1 | 0.1 | 0.1 | 0.1 | 0.1 |
| Component (G) | | MEK | 6.7 | 6.7 | 6.7 | 6.7 | 6.7 | 6.7 | 6.7 | 6.7 | 6.7 | 6.7 | 6.7 | 6.7 | 6.7 |
| Total amount of non-volatile component (parts by mass) | | | 187.45 | 181.01 | 174.96 | 167.45 | 181.01 | 181.01 | 181.01 | 181.01 | 181.01 | 181.01 | 181.01 | 181.01 | 158.85 |
| Total amount of Components (A) and (C) (% by mass) | | | 96.0 | 95.9 | 95.7 | 95.5 | 95.9 | 95.9 | 95.9 | 95.9 | 95.9 | 95.9 | 95.9 | 95.9 | 95.3 |
| Total amount of Components (A) and (C) (% by volume) | | | 79.9 | 79.9 | 80.0 | 79.9 | 79.9 | 79.9 | 79.9 | 79.9 | 79.9 | 79.9 | 79.9 | 79.9 | 79.8 |
| Relative magnetic permeability (20MHz) | | | 24.3 | 25 | 25.1 | 25 | 23.9 | 23.9 | 24 | 24.9 | 24 | 23.6 | 24.5 | 25 | 19 |
| tan *δ* (20MHz) | | | 0.033 | 0.033 | 0.028 | 0.033 | 0.025 | 0.032 | 0.033 | 0.029 | 0.035 | 0.057 | 0.045 | 0.055 | 0.022 |
| Determination of magnetic permeability | | | ○ | ○ | ○ | ○ | ○ | ○ | ○ | ○ | ○ | ○ | ○ | ○ | × |
| Determination of magnetic loss tangent | | | ○ | ○ | ○ | ○ | ○ | ○ | ○ | ○ | ○ | × | ○ | × | ○ |
| Melt viscosity (poise) | | | 17000 | 15200 | 18700 | 21500 | 22000 | 16800 | 16000 | 21300 | 15500 | 18700 | 37800 | 16200 | 24800 |
| Determination of melt viscosity | | | O | O | O | O | O | O | o | ○ | O | O | × | O | O |

| | | | | | | | | | | | | | | | |
|---|---|---|---|---|---|---|---|---|---|---|---|---|---|---|---|
| * The total amount (% by mass) of the component (A) and the component (C) denotes the content relative to 100% by mass of the non-volatile components in the resin composition, and the total amount (% by volume) of the component (A) and the component (C) denotes the content relative to 100% by volume of the non-volatile components in the resin composition. | | | | | | | | | | | | | | | |

## Claims

1. A resin composition comprising:
a component (A) that is an Fe-Ni-Si-Cr-based alloy magnetic powder; and
a component (B) that is a thermosetting resin, wherein
a content of Cr contained in the component (A) is 0.1% by mass or more and 6% by mass or less relative to 100% by mass of the component (A).

2. The resin composition according to claim 1, further comprising a component (C) that is a magnetic powder other than an Fe-Ni-Si-Cr-based alloy magnetic powder.

3. The resin composition according to claim 2, wherein the component (C) contains a ferrite-based magnetic powder.

4. The resin composition according to claim 2 or 3, wherein the component (C) contains a ferrite-based magnetic powder containing at least one element selected from the group consisting of Mn, Zn, Ni, and Cu.

5. The resin composition according to any one of claims 2 to 4, wherein the component (C) has a smaller average particle diameter than that of the component (A).

6. The resin composition according to any one of claims 1 to 5, wherein the component (B) contains an epoxy resin (B-1).

7. The resin composition according to any one of claims 1 to 6, wherein the component (B) contains a curing agent (B-2) .

8. The resin composition according to any one of claims 1 to 7, further comprising a dispersant (E).

9. The resin composition according to any one of claims 1 to 8, further comprising a curing accelerator (F).

10. The resin composition according to any one of claims 1 to 9, wherein a content of Si contained in the component (A) is 0.2% by mass or more and 5% by mass or less relative to 100% by mass of the component (A).

11. The resin composition according to any one of claims 1 to 10, wherein a content of Cr contained in the component (A) is 0.5% by mass or more and 6% by mass or less relative to 100% by mass of the component (A).

12. The resin composition according to any one of claims 1 to 11, wherein an amount of the component (A) is 40% by mass or more relative to 100% by mass of non-volatile components in the resin composition.

13. The resin composition according to any one of claims 1 to 12, wherein an amount of the component (A) is 30% by volume or more relative to 100% by volume of non-volatile components in the resin composition.

14. The resin composition according to any one of claims 2 to 13, wherein a total amount of the component (A) and the component (C) is 70% by mass or more relative to 100% by mass of non-volatile components in the resin composition.

15. The resin composition according to any one of claims 2 to 14, wherein a total amount of the component (A) and the component (C) is 50% by volume or more relative to 100% by volume of non-volatile components in the resin composition.

16. The resin composition according to any one of claims 1 to 15, serving as a hole-filling resin composition.

17. A cured product of the resin composition according to any one of claims 1 to 16.

18. A magnetic paste comprising the resin composition according to any one of claims 1 to 16.

19. A resin sheet comprising a support and a resin composition layer provided on the support, wherein
the resin composition layer includes the resin composition according to any one of claims 1 to 16.

20. A circuit substrate comprising a substrate having holes and a cured product of the resin composition according to any one of claims 1 to 16 with which the holes are filled.

21. A circuit substrate comprising a cured product layer including a cured product of the resin composition according to any one of claims 1 to 16.

22. An inductor substrate comprising a circuit substrate according to claim 20 or 21.
